# EUROPEAN PATENT APPLICATION

(11) **EP 4 600 726 A1**
(43) Date of publication of application: **13.08.2025**
(21) Application number: 23955011.4
(22) Date of filing: 15.11.2023
(51) Int. Cl.: G02F 1/13357, H10H 20/857

(54) **WIRING SUBSTRATE AND MANUFACTURING METHOD THEREFOR, BACKPLANE, AND DISPLAY APPARATUS**

(71) Applicant: BOE TECHNOLOGY GROUP CO., LTD., Beijing 100015 (CN); BOE MLED Technology Co., Ltd., Beijing 100176 (CN); Beijing BOE Technology Development Co., Ltd., Daxing District Beijing 100176 (CN)
(72) Inventor: ZHAI, Ming, Daxing District Beijing 100176 (CN); LIU, Chao, Daxing District Beijing 100176 (CN); WANG, Lili, Daxing District Beijing 100176 (CN); FENG, Shanshan, Daxing District Beijing 100176 (CN); ZHAO, Jingping, Daxing District Beijing 100176 (CN); WANG, Jing, Daxing District Beijing 100176 (CN); LIU, Mengqing, Daxing District Beijing 100176 (CN); WANG, Huaimin, Daxing District Beijing 100176 (CN); JIA, Mingming, Daxing District Beijing 100176 (CN); SHI, Lingyun, Daxing District Beijing 100176 (CN); QI, Qi, Daxing District Beijing 100176 (CN)
(74) Representative: Hoffmann Eitle
(86) International application number: PCT/CN2023/131810
(87) International publication number: WO 2025/102264

(57) **Abstract**

Disclosure is a wiring substrate. The wiring substrate includes a substrate and a plurality of connection lines located on the substrate. The substrate includes a first main surface and a second main surface arranged opposite to each other in a thickness direction of the substrate, and side surfaces between the first main surface and the second main surface. The side surfaces include a set side surface. The plurality of connection lines are located on the substrate, and the connection lines extend from the first main surface to the second main surface through the set side surface. Any one of the plurality of connection lines includes: a first surface and a second surface arranged opposite to each other. The first surface is closer to the substrate than the second surface, and an area of the first surface is greater than an area of the second surface.

## Description

### TECHNICAL FIELD

The present disclosure relates to the field of display technologies, and in particular, to a wiring substrate, a method of manufacturing a wiring substrate, a backplane, and a display device.

### BACKGROUND

Mini light-emitting diode (Mini LED) display devices or micro light-emitting diode (Micro LED) display devices have good application prospects due to their advantages of high luminance, clear display image, low power consumption, etc.

### SUMMARY

In an aspect, a wiring substrate is provided. The wiring substrate includes a substrate and a plurality of connection lines located on the substrate. The substrate includes a first main surface and a second main surface arranged opposite to each other in a thickness direction of the substrate, and side surfaces between the first main surface and the second main surface, and the side surfaces include a set side surface. The plurality of connection lines are located on the substrate, and the connection lines extend from the first main surface through the set side surface to the second main surface. Any one connection line of the plurality of connection lines includes a first surface and a second surface that are arranged opposite to each other, the first surface is closer to the substrate than the second surface, and an area of the first surface is greater than an area of the second surface.

In some embodiments, any one connection line of the plurality of connection lines has a plurality of sections made by planes parallel to the substrate cutting the connection line; and among any two sections of the plurality of sections, an area of a section closer to the substrate is smaller than an area of another section farther away from the substrate.

In some embodiments, a section of any one connection line of the plurality of connection lines made by a plane perpendicular to an extending direction of the connection line cutting the connection line is in a shape of a trapezoid.

In some embodiments, in a line width direction of the connection line, the connection line includes two first side surfaces arranged opposite to each other; the first side surfaces are used to connect the first surface and the second surface; and a projection length of an orthographic projection of a first side surface on the substrate in the line width direction of the connection line is in a range of 6 µm to 25 µm.

In some embodiments, any one connection line of the plurality of connection lines includes: a first line segment, a second line segment and a third line segment that are connected in sequence; the first line segment is located on the first main surface, the second line segment is located on the set side surface, and the third line segment is located on the second main surface; the second main surface has a fan-out region, and a length of the fan-out region in a direction perpendicular to a direction in which the plurality of connection lines are arranged is in a range of 3 mm to 20 mm; the third line segment includes a fan-out portion located in the fan-out region; the fan-out portion gradually approaches a first central axis of the wiring substrate from an end of the fan-out portion close to the second line segment to an end of the fan-out portion away from the second line segment; and the first central axis is perpendicular to the direction in which the plurality of connection lines are arranged.

In some embodiments, a length of the first line segment is in a range of 0.15 mm to 0.4 mm.

In some embodiments, the second main surface further has a lead-out region, and the lead-out region is located on a side of the fan-out region close to the set side surface; the third line segment further includes a lead-out portion located in the lead-out region, the lead-out portion is used to connect the second line segment and the fan-out portion, and a length of the lead-out portion is in a range of 0.06 mm to 1 mm.

In some embodiments, in any one connection line of the plurality of connection lines, extending directions of the lead-out portion, the first line segment, and the second line segment that are connected in sequence are located in a same plane. Furthermore, the plane is perpendicular to the set side surface.

In some embodiments, a ratio of a thickness of the first line segment to a thickness of the second line segment is in a range of 0.3 to 0.8; and/or a ratio of a thickness of the third line segment to the thickness of the second line segment is in a range of 0.3 to 0.8.

In some embodiments, a thickness of the second line segment is in a range of 0.9 µm to 5 µm; a thickness of the first line segment is in a range of 0.6 µm to 2 µm; and/or a thickness of the third line segment is in a range of 0.6 µm to 2 µm.

In some embodiments, the wiring substrate further includes a plurality of first electrodes, the first electrodes are located on the first main surface and close to the set side surface, and a first electrode is electrically connected to a first line segment of the connection line.

In another aspect, a mask assembly is provided. The mask assembly is used for manufacturing the plurality of connection lines in the wiring substrate as described in any of the above embodiments. The mask assembly includes a carrier film and an organic photosensitive material layer located on the carrier film. The organic photosensitive material layer includes a plurality of hollow regions; any one hollow region of the plurality of hollow regions has a plurality of sections made by planes parallel to the carrier film cutting the hollow region; among the plurality of sections, an area of a section closest to the carrier film is smaller than an area of a section farthest from the carrier film; in an extending direction of any one hollow region, the hollow region includes a first hollow portion, a second hollow portion and a third hollow portion that are communicated in sequence; the third hollow portion in any one the hollow region gradually approaches a second central axis of the mask assembly from a side of the third hollow portion close to the second hollow portion to a side of the third hollow portion away from the second hollow portion; and the second central axis is perpendicular to a direction in which the plurality of hollow regions are arranged.

In some embodiments, any one hollow region of the plurality of hollow regions has the plurality of sections made by planes parallel to the carrier film cutting the hollow region; and among any two sections of the plurality of sections, an area of a section closer to the carrier film is smaller than an area of a section farther away from the carrier film.

In some embodiments, a section of any one hollow region of the plurality of hollow regions made by a plane perpendicular to an extending direction of the hollow region cutting the hollow region is in a shape of a trapezoid.

In some embodiments, in a direction in which the plurality of hollow regions are arranged, the organic photosensitive material layer further includes first photosensitive sub-portions; a first photosensitive sub-portion separates two adjacent hollow regions; in the direction in which the plurality of hollow regions are arranged, the first photosensitive sub-portion includes two second side surfaces; and a second side surface intersects with the carrier film to form a first angle, and the first angle is in a range of 40° to 80°.

In some embodiments, a projection length of an orthographic projection of the second side surface on the carrier film in the direction in which the plurality of hollow regions are arranged is in a range of 6 µm to 25 µm.

In some embodiments, a thickness of the organic photosensitive material layer is in a range of 25 µm to 50 µm.

In some embodiments, in an extending direction of any one hollow region, the hollow region and an edge of the organic photosensitive material layer have a first spacing therebetween, and a length of the first spacing is greater than or equal to 2 mm.

In yet another aspect, a backplane is provided. The backplane includes a plurality of functional elements, at least one circuit board and the wiring substrate as described in any one of the above embodiments. An end of the connection line in the wiring substrate is connected to a functional element, and another end of the connection line is connected to the circuit board.

In yet another aspect, a display device is provided. The display device includes a backlight module and a liquid crystal display panel. The liquid crystal display panel is located on a light exit side of the backlight module. The backlight module includes the backplane as described above, and the functional elements include light-emitting diodes.

In yet another aspect, a display device is provided. The display device includes the backplane as described in any one of the above embodiments, and the functional elements include light-emitting diodes.

### BRIEF DESCRIPTION OF THE DRAWINGS

In order to describe technical solutions in the present disclosure more clearly, the accompanying drawings to be used in some embodiments of the present disclosure will be introduced briefly. However, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a schematic plan view of a display device, in accordance with some embodiments;
FIG. 2 is a structural diagram of a display device, in accordance with some embodiments;
FIG. 3 is a structural diagram of a display device, in accordance with some other embodiments;
FIG. 4 is a schematic plan view of a front of a backplane, in accordance with some possible implementations;
FIG. 5 is a schematic plan view of a back of a backplane, in accordance with some possible implementations;
FIG. 6 is a partial sectional view of a backplane, in accordance with some possible implementations;
FIG. 7 is a schematic plan view of a front of a wiring substrate, in accordance with some embodiments;
FIG. 8 is a schematic plan view of a back of a wiring substrate, in accordance with some embodiments;
FIG. 9 is a side view of a wiring substrate, in accordance with some embodiments;
FIG. 10 is a sectional view taken along the line C-C' in FIG. 8;
FIG. 11 is a schematic partial plan view of a front of a wiring substrate, in accordance with some embodiments;
FIG. 12 is a schematic partial plan view of a front of a wiring substrate, in accordance with some other embodiments;
FIG. 13 is a partial view of connection lines, in accordance with some embodiments;
FIG. 14 is a partial view of connection lines, in accordance with some other embodiments;
FIG. 15 is a partial view of connection lines, in accordance with yet some other embodiments;
FIG. 16 is a partial view of connection lines, in accordance with yet some other embodiments;
FIG. 17 is a partial view of connection lines, in accordance with yet some other embodiments;
FIG. 18 is a partial view of connection lines, in accordance with yet some other embodiments;
FIG. 19 is a sectional view of a wiring substrate, in accordance with some embodiments;
FIG. 20 is a structural diagram of a mask assembly, in accordance with some embodiments;
FIG. 21 is a sectional view taken along the line V-V' in FIG. 20;
FIG. 22 is a flow diagram of a method of manufacturing a wiring substrate, in accordance with some embodiments;
FIG. 23 is a diagram showing a structure corresponding to step S2 in FIG. 22;
FIG. 24 is a diagram showing another structure corresponding to step S2 in FIG. 22;
FIG. 25 is a diagram showing yet another structure corresponding to step S2 in FIG. 22;
FIG. 26 is a diagram showing yet another structure corresponding to step S2 in FIG. 22;
FIG. 27 is a diagram showing a structure corresponding to step S3 in FIG. 22;
FIG. 28 is a diagram showing another structure corresponding to step S3 in FIG. 22; and
FIG. 29 is a diagram showing yet another structure corresponding to step S3 in FIG. 22.

### DETAILED DESCRIPTION

The technical solutions in some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and claims, the term "comprise" and other forms thereof such as the third-person singular form "comprises" and the present participle form "comprising" are construed as an open and inclusive meaning, i.e., "included, but not limited to". In the description of the specification, terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described herein may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, features defined with "first" and "second" may explicitly or implicitly include one or more of the features. In the description of the embodiments of the present disclosure, the terms "a plurality of", "the plurality of" and "multiple" each mean two or more unless otherwise specified.

In the description of some embodiments, the expressions "coupled" and "connected" and derivatives thereof may be used. The term "connected" shall be understood in a broad sense. For example, the term "connected" may represent a fixed connection, or a detachable connection, or a one-piece connection; alternatively, the term "connected" may represent a direct connection, or an indirect connection through an intermediate medium. The term "coupled", for example, indicates that two or more components are in direct physical or electrical contact. The term "coupled" or "communicatively coupled" may also indicate that two or more components are not in direct contact with each other, but still cooperate or interact with each other. The embodiments disclosed herein are not necessarily limited to the context herein.

The phrase "at least one of A, B and C" has the same meaning as the phrase "at least one of A, B or C", both including following combinations of A, B and C: only A, only B, only C, a combination of A and B, a combination of A and C, a combination of B and C, and a combination of A, B and C.

The phrase "A and/or B" includes following three combinations: only A, only B, and a combination of A and B.

As used herein, the term "if" is, optionally, construed to mean "when" or "in a case where" or "in response to determining" or "in response to detecting", depending on the context. Similarly, the phrase "if it is determined" or "if [a stated condition or event] is detected" is, optionally, construed to mean "in a case where it is determined" or "in response to determining" or "in a case where [the stated condition or event] is detected" or "in response to detecting [the stated condition or event]", depending on the context.

The phrase "applicable to" or "configured to" as used herein means an open and inclusive expression, which does not exclude devices that are applicable to or configured to perform additional tasks or steps.

In addition, the use of the phrase "based on" or "according to" is meant to be open and inclusive, since a process, step, calculation or other action that is "based on" or "according to" one or more of the stated conditions or values may, in practice, be based on or according to additional conditions or values exceeding those stated.

The term such as "about", "substantially" or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular" or "equal" as used herein includes a stated case and a case similar to the stated case within an acceptable range of deviation determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, that a difference between two equals is less than or equal to 5% of either of the two equals.

It will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views as idealized exemplary drawings. In the accompanying drawings, thicknesses of layers and sizes of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Thus, the regions shown in the accompanying drawings are schematic in nature, and their shapes are not intended to show actual shapes of regions in a device, and are not intended to limit the scope of the exemplary embodiments.

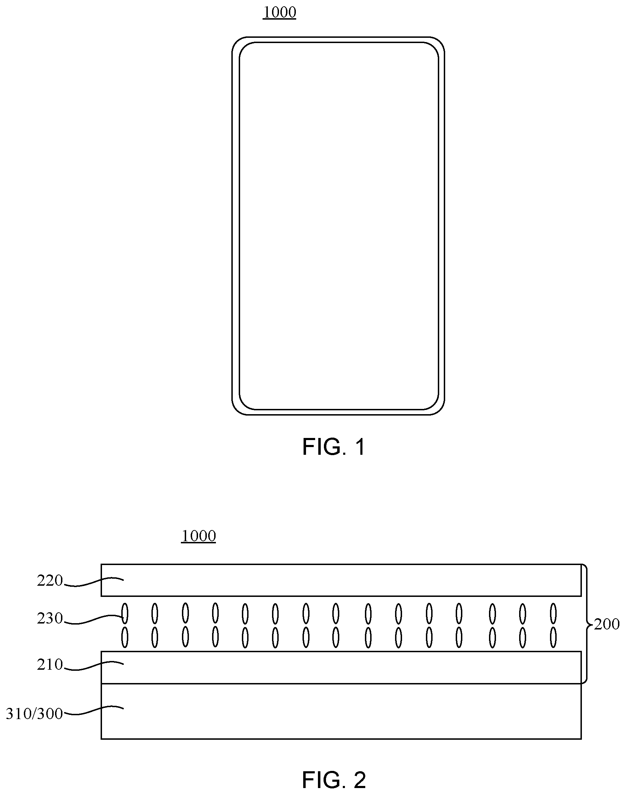

FIG. 1 is a schematic plan view of a display device, in accordance with some embodiments.

As shown in FIG. 1, some embodiments of the present disclosure provide a display device 1000.

For example, the display device 1000 may be any device that displays images whether in motion (e.g., videos) or stationary (e.g., static images), and whether textual or graphical. More specifically, it is expected that the display device in the embodiments may be implemented in or associated with a plurality of electronic devices. The plurality of electronic devices may include (but are not limit to), for example, mobile telephones, wireless devices, personal data assistants (PDAs), hand-held or portable computers, GPS receivers/navigators, cameras, MP4 video players, video cameras, game consoles, watches, clocks, calculators, TV monitors, flat panel displays, computer monitors, car displays (such as odometer displays), navigators, cockpit controllers and/or displays, camera view displays (such as rear view camera displays in vehicles), electronic photos, electronic billboards or indicators, projectors, building structures, packagings and aesthetic structures (such as displays for images of a piece of jewelry).

For example, the display device 1000 may be a liquid crystal display (LCD) device, a mini light-emitting diode (Mini LED) display device, and a micro light-emitting diode (Micro LED) display device.

FIG. 2 is a structural diagram of a display device, in accordance with some embodiments.

As shown in FIG. 2, in the case where the display device 1000 is a liquid crystal display device, in some embodiments, the display device 1000 includes a backlight module 300 and a liquid crystal display panel 200. The liquid crystal display panel 200 is located on a light exit side of the backlight module 300. The backlight module 300 is configured to provide light for the liquid crystal display panel 200, so that the liquid crystal display panel 200 is capable of displaying images.

The liquid crystal display panel 200 mainly includes an array substrate 210, an opposite substrate 220, and a liquid crystal layer 230 disposed between the array substrate 210 and the opposite substrate 220. In some examples, the opposite substrate 220 may be a color filter (CF) substrate.

As shown in FIG. 2, in some embodiments, the backlight module 300 includes a backplane 310. The backplane 310 is configured to provide light for the liquid crystal display panel, so that the liquid crystal display panel is capable of displaying images.

It will be understood that light may be emitted by the backlight module 300 and be incident on the liquid crystal layer 230. The intensity of light passing through the liquid crystal layer 230 is adjusted by adjusting the arrangement of liquid crystal molecules in the liquid crystal layer 230, so that the intensity of light incident on the opposite substrate 220 is adjusted. The opposite substrate 220 is a CF substrate. In this way, the display device 1000 realizes a function of displaying color images by adjusting the intensity of light incident on photoresist units of different colors.

In some examples, the backlight module in the display device 1000 may further include optical film(s), and the optical film(s) are located on a side of the backplane 310 proximate to the liquid crystal display panel. The optical film(s) may include a reflective film, a diffuser plate, brightness enhancement film (prism film), diffuser sheet, etc., which may be used to improve brightness and uniformity of light.

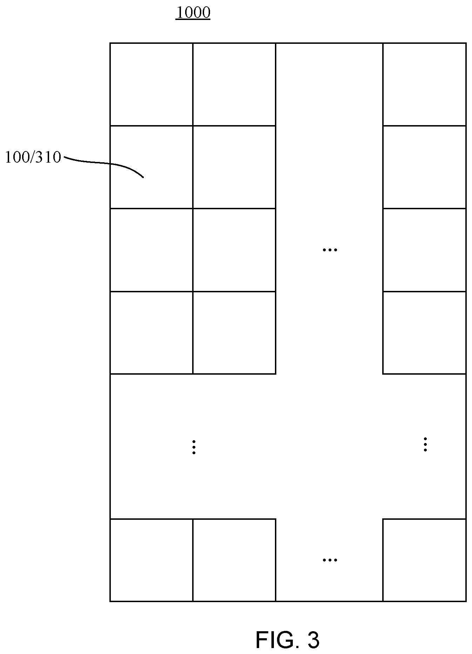

FIG. 3 is a structural diagram of a display device, in accordance with some other embodiments.

As shown in FIG. 3, in the case where the display device 1000 is a Mini LED display device or a Micro LED display device, in some embodiments, the display device 1000 includes a display panel, and the display panel includes at least one backplane 310, and the backplane 310 is capable of displaying images.

The difference between the display device 1000 shown in FIG. 3 and the display device 1000 shown in FIG. 2 is that: in the display device 1000 shown in FIG. 3, there is no need to provide a backlight module, and the backplane 310 in the display panel is directly used to emit at least one of red light, green light or blue light, so that the display device 1000 realizes color display.

In some examples, the display device 1000 may include a plurality of backplanes 310, and the plurality of backplanes 310 are tiled together to form the display device 1000. Alternatively, the display device 1000 may include one backplane 310.

In some examples, the display device 1000 may further include an anti-reflection film layer and a protective cover plate. The anti-reflection film layer is located between the wiring substrate 100 and the protective cover plate. The anti-reflection film layer includes a polarizer, and the polarizer may be a circular polarizer. Here, the polarizer may reduce the reflection of external light and prevent glare caused by the wiring substrate 100 reflecting ambient light.

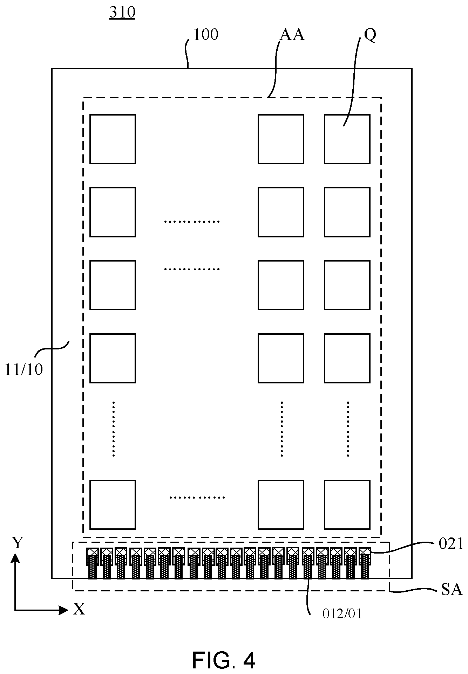

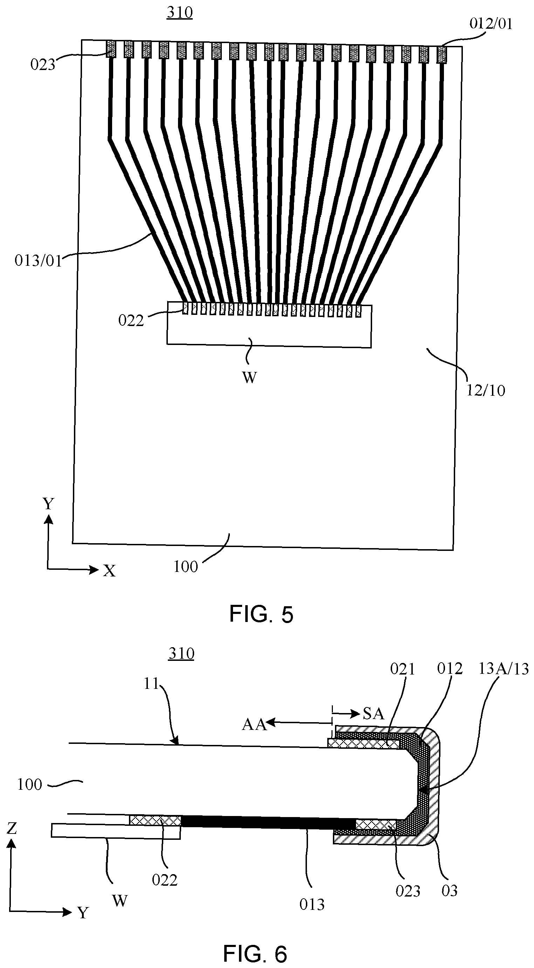

FIG. 4 is a schematic plan view of a front of a backplane according to some possible implementations. FIG. 5 is a schematic plan view of a back of a backplane according to some possible implementations. FIG. 6 is a partial sectional view of a backplane according to some possible implementations. FIG. 4 is a schematic plan view of the backplane 310 as viewed from a first main surface 11 of a substrate 10 in the backplane 310. FIG. 5 is a schematic plan view of the backplane 310 as viewed from a second main surface 12 of the substrate 10 in the backplane 310.

As shown in FIGS. 4 to 6, some embodiments of the present disclosure provide a backplane 310, and the backplane 310 includes a main functional region (also referred to as active area (AA) or active main functional region) AA and a peripheral region SA. The peripheral region SA is located on at least one side (e.g., one side, or four sides which include upper and lower sides and left and right sides) of the main functional region AA.

The backplane 310 includes a wiring substrate 100, a plurality of functional elements Q, and at least one circuit board W. The plurality of functional elements Q and the at least one circuit board W are all electrically connected to the wiring substrate 100. The wiring substrate 100 is provided therein with a plurality of connection lines. The plurality of functional elements Q may be electrically connected through conductive lines 110, and the functional elements Q and the circuit board W may be electrically connected through conductive lines 110.

For example, an end of at least one connection line in the wiring substrate 100 is electrically connected to a functional element Q, and another end of the at least one connection line is electrically connected to the circuit board W, so as to realize the electrical connection between the functional element Q and the circuit board W.

It will be noted that, in addition to the functional elements Q and the circuit board W, the backplane 310 may further include other electronic elements (not shown in the figures) such as a sensor chip, a capacitor, a resistor and an inductor.

In some examples, the functional elements Q may be light-emitting diodes (LEDs). The main functional region AA includes a plurality of LEDs, and the LEDs are located on the first main surface of the substrate of the wiring substrate 100.

For example, the LEDs may be Micro LEDs or Mini LEDs.

In the case where the display device 1000 is the liquid crystal display device, in some examples, the wiring substrate 100 is a backlight source of the display device 1000, which is configured to provide a light source for the liquid crystal display device. All LEDs may be controlled independently. Thus, the display device may realize local dimming, realize a high dynamic range (HDR) image effect, and improve the display quality of the display device 1000.

In the case where the display device 1000 is the Mini LED display device or the Micro LED display device, in some examples, the LEDs (e.g., Micro LEDs, Mini LEDs, etc.) may emit light to directly display images.

For example, the LEDs may be light-emitting elements capable of emitting light of the same color. For example, the LEDs may all be blue LEDs, red LEDs, green LEDs or yellow LEDs. In this way, the display device 1000 may be a display device of a single color, which may be a display device such as an instrument dial, a signal indicator screen, etc.

For example, the LEDs may include LEDs of multiple different colors. For example, the LEDs may include at least two of red LEDs, green LEDs, blue LEDs, yellow LEDs, etc., and the LEDs of different colors may be independently controlled. In this way, the display device 1000 may perform color display through light mixing.

In some examples, as shown in FIG. 4, the plurality of LEDs in the wiring substrate 100 are arranged in a plurality of rows and a plurality of columns. For convenience of the description, the plurality of LEDs in the present disclosure are described by taking an example in which the plurality of LEDs are arranged in a matrix.

For example, the plurality of LEDs in the wiring substrate 100 are arranged in an array with equal spacing along a first direction (row direction) X and a second direction (column direction) Y. In this way, it may be possible to improve the uniformity of the distribution of the LEDs in the wiring substrate 100.

In some examples, the first direction X and the second direction Y may be approximately perpendicular to each other. In this case, an included angle between the first direction X and the second direction Y is approximately equal to 90°. For example, the included angle between the first direction X and the second direction Y is 85°, 90° or 95°.

In some examples, the circuit board W may be an integrated circuit (IC). The circuit board W may be used to provide signals for the functional elements Q to drive the functional elements Q.

In some possible implementations, referring to FIGS. 4 to 6, the wiring substrate 100 in the backplane 310 includes a substrate 10. The substrate 10 includes a first main surface 11 and a second main surface 12 that are arranged opposite to each other in a thickness direction (third direction) Z of the substrate 10, and side surfaces 13 located between the first main surface 11 and the second main surface 12. The side surfaces 13 are used to connect the first main surface 11 and the second main surface 12. A plurality of side surfaces 13 include a set side surface 13A corresponding to the peripheral region SA. It should be noted that the "set side surface S31" refers to a side surface 13 corresponding to the peripheral region SA among the plurality of side surfaces 13 of the substrate 10.

The thickness direction (third direction) Z of the substrate 10 is perpendicular to the first direction X, and the thickness direction (third direction) Z of the substrate 10 is perpendicular to the second direction Y.

The wiring substrate 100 in the backplane 310 includes a plurality of fan-out lines 013, a plurality of connection lines 012, a plurality of first connection electrodes 021, a plurality of second connection electrodes 022, and a plurality of connection pads 023.

The plurality of first connection electrodes 021 are located on a side of the first main surface 11 of the substrate 10 away from the second main surface 12, and the plurality of first connection electrodes 021 are located in the peripheral region SA.

The plurality of fan-out lines 013 are located on a side of the second main surface 12 of the substrate 10 away from the first main surface 11, and the plurality of fan-out lines 013 are arranged at intervals along the first direction X. In the first direction X, a total length occupied by an end of all the fan-out lines 013 closest to the set side surface 13A is greater than a total length occupied by an end of all the fan-out lines 013 farthest from the set side surface 13A; and the total length occupied by the end of all the fan-out lines 013 farthest from the set side surface 13A is adapted to a length of the circuit board W, so as to facilitate electrical connection between the fan-out lines 013 and gold finger structures of the circuit board W in the backplane 310.

The plurality of second connection electrodes 022 are located on the side of the second main surface 12 of the substrate 10 away from the first main surface 11, and the second connection electrodes 022 are located on a side of the fan-out lines 013 away from the set side surface 13A.

The plurality of connection pads 023 are located on the side of the second main surface 12 of the substrate 10 away from the first main surface 11, and the connection pads 023 are located on a side of the fan-out lines 013 close to the set side surface 13A.

The plurality of connection lines 012 extend from the first main surface 11 to the second main surface 12 through the set side surface 13A. Among the plurality of connection lines 012, an end of any one connection line 012 located on the first main surface 11 may be electrically connected to a first connection electrode 021 located on the first main surface 11, and an end of the any one connection line 012 located on the second main surface 12 may be electrically connected to a connection pad 023 located on the second main surface 12.

Thus, the first connection electrode 021 located on the first main surface 11 and the fan-out line 013 located on the second main surface 12 may be electrically connected through the connection line 012. The first connection electrode 021 may be used to be electrically connected to the functional element Q in the main functional region AA of the wiring substrate 100. The fan-out line 013 may be electrically connected to the circuit board W located on the side of the second main surface 12 of the substrate 10 away from the first main surface 11 through the second connection electrode 022.

Based on the above structure, in the backplane 310, the circuit board W may be arranged on the second main surface 12 of the substrate 10. That is, a bonding region of the backplane 310 may be provided on the second main surface 12 of the substrate 10. The circuit board W transmits the signal to the functional element Q located in the main functional region AA of the wiring substrate 100 through the second connection electrode 022, the fan-out line 013, the connection pad 023, the connection line 012 and the first connection electrode 021. Therefore, the backplane 310 is controlled to display images.

Furthermore, since the circuit board W is disposed on the second main surface 12 of the substrate 10, when the backplane 310 is subjected to a bonding process, no edge of the backplane 310 needs to be bent during the bonding process, which may be conducive to realizing a narrow bezel of the backplane 310, which may be widely used in tiled application products.

In some examples, as shown in FIG. 6, the backplane 310 further includes a protective layer 03, and the protective layer 03 is made of an insulating material. The protective layer 03 is located on a side of the plurality of connection lines 012 away from the substrate 10. The protective layer 03 covers the plurality of connection lines 012, so as to fix and protect the plurality of connection lines 012 and prevent the connection lines 012 from cracking or falling off.

However, the inventors found that when manufacturing the above-mentioned backplane 310, a plurality of first connection electrodes 021 need to be formed in the peripheral region SA of the first main surface 11 of the substrate 10 in the wiring substrate 100, a plurality of fan-out lines 013, a plurality of second connection electrodes 022 and a plurality of connection pads 023 need to be formed on the second main surface 12 of the substrate 10, and connection lines 012 for connecting the first connection electrodes 021 and the connection pads 023 need to be formed. That is, both the first main surface 11 and the second main surface 12 of the substrate 10 in the wiring substrate 100 need to be designed and fabricated for wiring, which is relatively complicated. After electrical structures are formed on one main surface of the substrate 10, it needs to be turned over to form electrical structures on another main surface. However, when the wiring substrate 100 is turned over, circuits on the opposite surfaces are easily scratched, resulting in a low process yield and high costs of the wiring substrate 100 in the backplane 310.

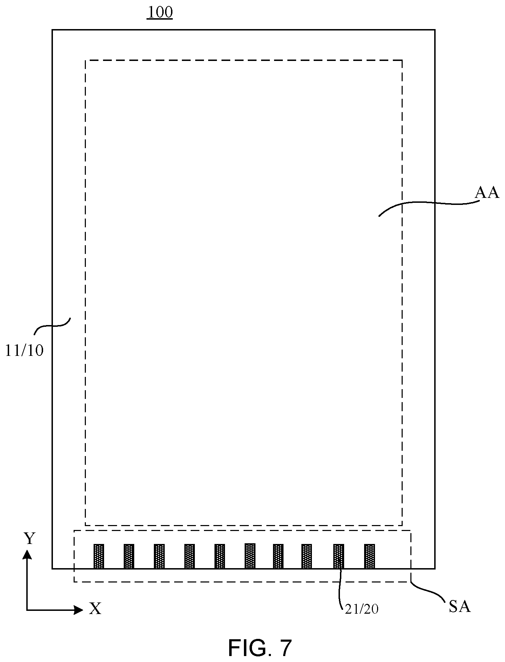

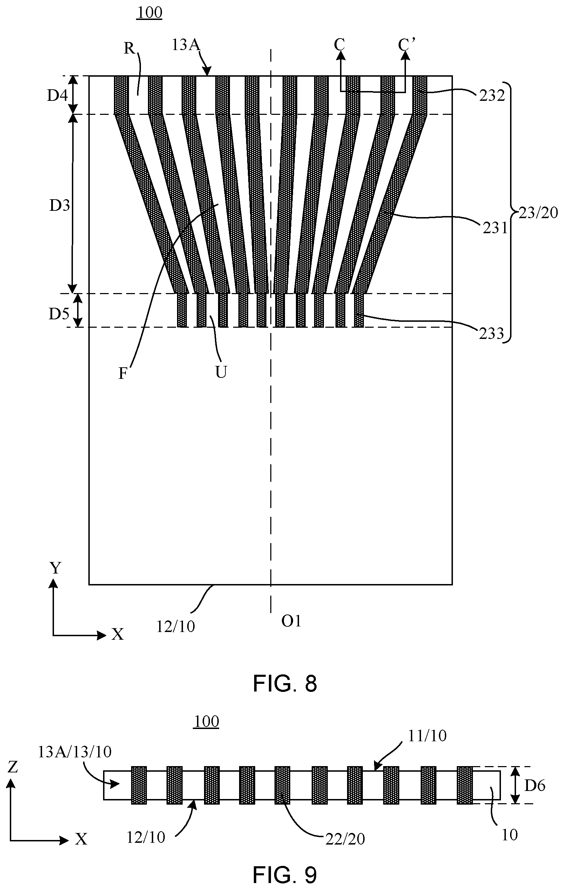

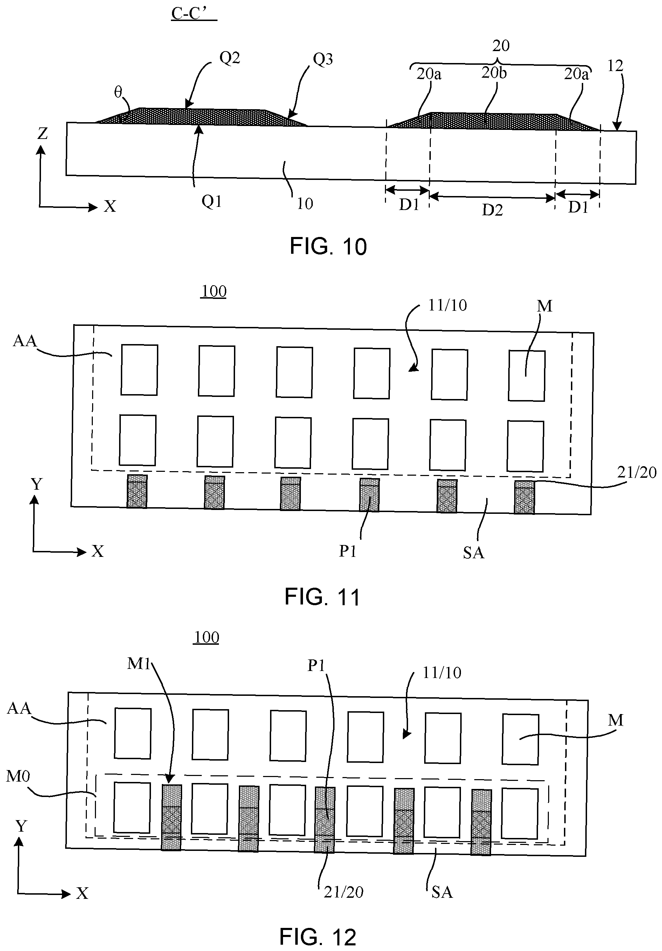

FIG. 7 is a schematic plan view of a front of a wiring substrate according to some embodiments. FIG. 8 is a schematic plan view of a back of a wiring substrate according to some embodiments. FIG. 9 is a side view of a wiring substrate according to some embodiments. FIG. 10 is a sectional view taken along the line C-C' in FIG. 8. FIG. 7 is a schematic plan view of a wiring substrate 100 as viewed from a first main surface 11 of a substrate 10 in the wiring substrate 100. FIG. 8 is a schematic plan view of a wiring substrate 100 as viewed from a second main surface 12 of a substrate 10 in the wiring substrate 100.

In light of this, some embodiments of the present disclosure provide a wiring substrate 100. As shown in FIGS. 7 to 10, the wiring substrate 100 includes a main functional region (also referred to as active area (AA) or active main functional region) AA and a peripheral region SA. The peripheral region SA is located on at least one side (e.g., one side, or four sides which include upper and lower sides and left and right sides) of the main functional region AA.

The wiring substrate 100 includes a substrate 10 and a plurality of connection lines 20 arranged along a first direction X on the substrate 10.

In some examples, the substrate 10 may be a flexible substrate. For example, the substrate 10 may be made of an organic material. For example, the substrate 10 may be made of any one of polyimide (PI), polycarbonate (PC) or polyvinyl chloride (PVC).

In some other examples, the substrate 10 may be a rigid substrate. For example, the rigid substrate may be a glass substrate or a polymethyl methacrylate (PMMA) substrate.

The plurality of connection lines 20 are located on the substrate 10, and the connection lines 20 extend from the first main surface 11 to the second main surface 12 through the set side surface 13A. Portions of the connection lines 20 formed on the first main surface 11 are located in the peripheral region SA. In this way, the connection lines 20 may be used to electrically connect components located on the first main surface 11 of the substrate 10 to components located on the second main surface 12 of the substrate 10.

Portions of the connection line 20 located on different surfaces of the substrate 10 are arranged in the same layer. That is, the connection line 20 is of a one-piece structure, and is not formed by connecting a plurality of lines.

It will be noted that, the "same layer" refers to a layer structure formed by forming a film layer for forming a specific pattern through a same film forming process and then performing a single patterning process using a same mask. Depending on different specific patterns, the patterning process may include exposure processes, development processes or etching processes, the specific patterns in the formed layer structure may be continuous or discontinuous, and these specific patterns may also be at different heights or have different thicknesses.

In the third direction Z, a minimum distance between a first surface Q1 of the connection line 20 and a second surface Q2 of the connection line 20 is greater than a minimum distance between a first side surface Q3 of the connection line 20 and the first surface Q1 of the connection line 20. Based on this, thicknesses of two edges of the connection line 20 may be small in a line width direction of the connection line 20. Based on the above structure of the connection line 20, it may be possible to meet the requirement of forming a plurality of connection lines 20 extending from the first main surface 11 to the second main surface 12 through the set side surface 13A by using one film forming process.

Since the connection lines 20 in this embodiment are formed by one film forming process, compared with the wiring substrate shown in FIGS. 4 to 6, both the first main surface 11 and the second main surface 12 of the substrate 10 in the wiring substrate 100 do not need to be designed and fabricated for wiring. Thus, it may be possible to mitigate the problem of low reliability of the wiring substrate caused by the design and fabricating of wiring on both surfaces of the wiring substrate 100, and in turn improve the quality of the wiring substrate 100. In addition, since the wiring substrate 100 has a simple structure, it is conducive to reducing the costs of the wiring substrate 100 and realizing mass production.

In some examples, the connection line 20 may be of a stacked structure. In this way, the connection line may have good conductivity, and the service life may be extended.

The stacked structure includes a buffer layer, a main conductive layer and a protective layer, and the main conductive layer is located between the protective layer and the buffer layer.

The main conductive layer in the stacked structure may be made of copper (Cu), aluminum (Al), molybdenum (Mo), etc. Considering that copper has lower resistance in practical applications, the main conductive layer may be made of copper.

The buffer layer and the protective layer in the stacked structure may each be made of inert metal or other alloy materials such as an alloy including molybdenum, titanium (Ti), nickel-chromium, or the like.

For example, the stacked structure may be Ti/Al/Ti, Ti/Cu/Ti, Mo/Cu/Mo, or MoNb/Cu/MoNb. However, the embodiments of the present disclosure are not limited thereto.

In some embodiments, as shown in FIG. 10, any one connection line 20 of the plurality of connection lines 20 has a plurality of sections made by planes parallel to the substrate 10 cutting the connection line 20. Among any two sections of the plurality of sections, an area of a section that is relatively closer to the substrate 10 is less than an area of a section that is relatively farther away from the substrate 10. Therefore, among any two sections of the plurality of sections, a width corresponding to the section that is relatively closer to the substrate 10 (i.e., a size of the section in the line width direction of the connection line 20) is less than a width corresponding to the section that is relatively farther away from the substrate 10 (i.e., a size of the section in the line width direction of the connection line 20).

Any one connection line 20 has a plurality of sections made by planes parallel to the substrate 10 cutting the connection line 20. A section closest to the substrate 10 among the plurality of sections may be understood as the first surface Q1. A section farthest from the substrate 10 among the plurality of sections may be understood as the second surface Q2.

In this way, a width of any one connection line 20 of the plurality of connection lines 20 on a side close to the substrate may be greater than a width of any one connection line 20 of the plurality of connection lines 20 on a side away from the substrate. Based on this, it may be further ensured that the thicknesses of two edges of the connection line 20 in the line width direction of the connection line 20 may be small.

In this way, it may be possible to meet the requirement of forming a plurality of connection lines 20 by using one film forming process. In addition, the plurality of connection lines 20 extending from the first main surface 11 to the second main surface 12 through the set side surface 13A may be formed simultaneously, which may mitigate the problem of low reliability of the wiring substrate caused by the design and fabricating of wiring on both surfaces of the wiring substrate 100, and in turn improve the quality of the wiring substrate 100.

In some examples, as shown in FIG. 10, any one connection line 20 of the plurality of connection lines 20 has a plurality of sections made by planes parallel to the substrate 10 cutting the connection line 20, and areas of the plurality of sections gradually decrease in a direction away from the substrate 10. Based on this, the first side surface Q3 of any one connection line 20 is relatively flat, so that the structure of the connection line 20 is relatively regular, which is conducive to improving the quality of the connection line 20.

In some embodiments, as shown in FIG. 10, a section of any one connection line 20 of the plurality of connection lines 20 made by a plane perpendicular to an extending direction of the connection line 20 cutting the connection line 20 is in a shape of a trapezoid. The "trapezoid" may be a regular trapezoid, the upper base of the "trapezoid" may be formed by the second surface Q2 of the connection line 20, the lower base of the "trapezoid" may be formed by the first surface Q1 of the connection line 20, and the two legs of the "trapezoid" may be formed by two first side surfaces Q3 of the connection line 20. That is, a length of the upper base of the regular trapezoid is less than a length of the lower base of the regular trapezoid.

In this way, it may be further ensured that the thicknesses of two edges of the connection line 20 in the line width direction of the connection line 20 may be small, it may be possible to meet the requirement of forming a plurality of connection lines 20 by using one film forming process, and it may mitigate the problem of low reliability of the wiring substrate caused by the design and fabricating of wiring on both surfaces of the wiring substrate 100, and in turn improve the quality of the wiring substrate 100. In addition, as the above structure, the structure of any connection line 20 may be more regular, which may improve the regularity and aesthetics of the wiring substrate 100.

In some examples, as shown in FIG. 10, a section of any one connection line 20 of the plurality of connection lines 20 made by a plane perpendicular to an extending direction of the connection line 20 cutting the connection line 20 is in a shape of an isosceles trapezoid.

In this way, areas of the two first side surfaces Q3 of the connection line 20 are substantially equal. Thus, during the patterning of the connection lines 20, the manufacturing process of the wiring substrate 100 may be simplified. In addition, the regularity and aesthetics of the wiring substrate 100 may be improved, and the quality of the connection lines 20 may be improved.

In some embodiments, as shown in FIG. 10, in any one connection line 20 in the wiring substrate 100, a portion included between a first side surface Q3 and the first surface Q1 is defined as a tail portion 20a of the connection line 20, and a portion included between the second surface Q2 and the first surface Q1 is defined as a main body 20b of the connection line 20.

That is, along the third direction Z, the portion between the first side surface Q3 and the first surface Q1 of the connection line 20 constitutes the tail portion 20a of the connection line 20, and the portion between the second surface Q2 and the first surface Q1 of the connection line 20 constitutes the main body portion 20b of the connection line 20. The main body portion 20b of the connection line 20 is located between the two tail portions 20a.

A thickness of the tail portion 20a of the connection line 20 close to the main body portion 20b of the connection line 20 is greater than a thickness of the tail portion 20a of the connection line 20 away from the main body portion 20b of the connection line 20, so that the thickness of the tail portion 20a of the connection line 20 is thinner as it is farther away from the main body portion 20b. Furthermore, based on the structure of the connection line 20 described above, it is conducive to meeting the requirement of forming a plurality of connection lines 20 by using one film forming process, and it may mitigate the problem of low reliability of the wiring substrate caused by the design and fabricating of wiring on both surfaces of the wiring substrate 100, and in turn improve the quality of the wiring substrate 100.

Considering an example in which the section of the connection line 20 made by the plane perpendicular to the extending direction of the connection line 20 cutting the connection line 20 is in a shape of a trapezoid, a section of the tail portion 20a of the connection line 20 made by the plane perpendicular to the extending direction of the connection line 20 cutting the connection line 20 is in a shape of a triangle.

Based on this, in the line width direction of the connection line 20, a length of the first side surface Q3 can may be understood as a length of the base of the triangle corresponding to the section.

It will be noted that the main body portion 20b and the tail portion 20a of any connection line 20 in the wiring substrate 100 are not two separately formed portions, but are several portions obtained by dividing the integrally formed connection line 20, to facilitate a clear introduction and description of the shape of the connection line 20.

In some embodiments, as shown in FIG. 10, in the line width direction of the connection line 20, the length D1 of the first side surface Q3 is in a range of 6 µm to 25 µm. That is, a projection length D1 of an orthographic projection of the first side surface Q3 on the substrate 10 in the line width direction of the connection line 20 is in a range of 6 µm to 25 µm. Since the length of the tail portion 20a of the connection line 20 depends on the length D1 of the first side surface Q3 of the connection line 20, the value range of the length D1 of the first side surface Q3 will affect the size of the tail portion 20a of the connection line 20.

In a case where the length D1 of the first side surface Q3 in the line width direction of the connection line 20 is equal to or close to 6 µm, the length D1 of the first side surface Q3 is relatively small, and the length of the tail portion 20a of the connection line 20 is relatively small. In this case, the tail portion 20a of the connection line 20 may be prevented from being too long and affecting the electrical performance of the connection line 20. In addition, the structure of the tail portion 20a of the connection line 20 may be utilized to meet the requirement of forming a plurality of connection lines 20 using one film forming process. It may mitigate the problem of low reliability of the wiring substrate caused by the design and fabricating of wiring on both surfaces of the wiring substrate 100, and in turn improve the quality of the wiring substrate 100.

In a case where the length D1 of the first side surface Q3 in the line width direction of the connection line 20 is equal to or close to 25 µm, the length D1 of the first side surface Q3 is relatively large, and the length of the tail portion 20a of the connection line 20 is relatively large. In this case, a first angle θ formed by the tail portion 20a of the connection line 20 may be small, which further facilitates meeting the requirement of forming a plurality of connection lines 20 by using one film forming process. It may mitigate the problem of low reliability of the wiring substrate caused by the design and fabricating of wiring on both surfaces of the wiring substrate 100, and in turn improve the quality of the wiring substrate 100. In addition, the requirement of electrical performance of the connection line 20 may also be satisfied.

In some examples, in the line width direction of the connection line 20, the length D1 of the first side surface Q3 is in a range of 6 µm to 15 µm.

In a case where the length D1 of the first side surface Q3 in the line width direction of the connection line 20 is in a range of 6 µm to 15 µm, it may meet the requirement of electrical performance of the connection line 20 and the requirement of forming a plurality of connection lines 20 by using one film forming process. It may mitigate the problem of low reliability of the wiring substrate caused by the design and fabricating of wiring on both surfaces of the wiring substrate 100, and in turn improve the quality of the wiring substrate 100.

For example, in the line width direction of the connection line 20, the length D1 of the first side surface Q3 is approximately any one of 6 µm, 7 µm, 8 µm, 9 µm, 10 µm, 11 µm, 12 µm, 13 µm, 14 µm or 15 µm. However, the embodiments of the present disclosure are not limited thereto.

For example, the length D1 of the first side surface Q3 in the line width direction of the connection line 20 is approximately 10 µm. In this case, the connection lines 20 may meet the requirement of forming a plurality of connection lines 20 by using one film forming process, thereby mitigating the problem of low reliability of the wiring substrate caused by the design and fabricating of wiring on both surfaces of the wiring substrate 100. In addition, the connection lines 20 may also have good electrical performance.

It will be noted that due to certain uncontrollable errors (such as manufacturing process errors, equipment accuracy, measurement errors, etc.), when the length D1 of the first side surface Q3 in the line width direction of the connection line 20 fluctuates within a range of ±10% × 10 µm, it can also be considered that the length D1 of the first side surface Q3 in the line width direction of the connection line 20 is equal to 10 µm.

In some embodiments, as shown in FIG. 10, in the line width direction of the connection line 20, a length of the second surface Q2 is in a range of 40 µm to 300 µm. Since a length of the main body portion 20b of the connection line 20 depends on a length D2 of the first side surface Q3 of the connection line 20, a value range of the length of the first side surface Q3 will affect the size of the main body portion 20b of the connection line 20.

In a case where the length D2 of the second surface Q2 in the line width direction of the connection line 20 is equal to or close to 40 µm, the length D2 of the second surface Q2 is relatively small, and the length of the main body portion 20b of the connection line 20 is relatively small, so that the line width of the connection line 20 is relatively small. In this case, it may be conducive to flexibly arranging the plurality of connection lines 20 in the wiring substrate 100, and meeting the requirements of the existing manufacturing process accuracy.

In a case where the length D2 of the second surface Q2 in the line width direction of the connection line 20 is equal to or close to 300 µm, the length D2 of the second surface Q2 is relatively large, and the length of the main body portion 20b of the connection line 20 is relatively large, so that the line width of the connection line 20 is relatively large. In this case, it may be conducive to flexibly arranging the plurality of connection lines 20 in the wiring substrate 100, and meeting the requirements of the existing manufacturing process accuracy. In this case, it is conducive to reducing the impedance of each connection line 20 in the wiring substrate 100 and reducing the power consumption in the wiring substrate 100. In addition, it may also avoid the problem that the line width of the connection line 20 is too large and a total number of connection lines 20 in the wiring substrate 100 needs to be greatly reduced, so as to meet the demand for the total number of connection lines 20 in the wiring substrate 100.

In some examples, in the line width direction of the connection line 20, the length D2 of the second surface Q2 is in a range of 40 µm to 100 µm.

When the length D2 of the second surface Q2 in the line width direction of the connection line 20 is in a range of 40 µm to 100 µm, it may be conducive to flexibly arranging the plurality of connection lines 20 in the wiring substrate 100, and meeting the requirements of the existing manufacturing process accuracy.

For example, in the line width direction of the connection line 20, the length D2 of the second surface Q2 is approximately any one of 40 µm, 50 µm, 60 µm, 70 µm, 80 µm, 90 µm, 100 µm, 150 µm, 200 µm, 250 µm or 300 µm. However, the embodiments of the present disclosure are not limited thereto.

For example, the length D2 of the second surface Q2 in the line width direction of the connection line 20 is approximately 80 µm. In this case, it is conducive to improving the flexibility of the plurality of connection lines 20 in the wiring substrate 100 and meeting the demand for the total number of connection lines 20 in the wiring substrate 100.

It will be noted that due to certain uncontrollable errors (such as manufacturing process errors, equipment accuracy, measurement errors, etc.), when the length D2 of the second surface Q2 in the line width direction of the connection line 20 fluctuates within a range of ±10% × 80 µm, it can also be considered that the length D2 of the second surface Q2 in the line width direction of the connection line 20 is equal to 80 µm.

In some embodiments, as shown in FIGS. 7 to 9, any one connection line 20 of the plurality of connection lines 20 in the wiring substrate 100 includes: a first line segment 21, a second line segment 22, and a third line segment 23 that are connected in sequence. The first line segment 21 is located on the first main surface 11, the second line segment 22 is located on the set side surface 13A, and the third line segment 23 is located on the second main surface 12.

The first line segment 21, the second line segment 22 and the third line segment 23 of the connection line 20 are arranged in the same layer. That is, the first line segment 21, the second line segment 22 and the third line segment 23 of the connection line 20 are not multiple line segments formed separately, but are several parts obtained by dividing the integrally formed connection line 20 based on its position on the substrate 10, so as to clearly introduce the shape of the connection line 20.

It will be noted that, the "same layer" refers to a layer structure formed by forming a film layer for forming a specific pattern through a same film forming process and then performing a single patterning process using a same mask. Depending on different specific patterns, the patterning process may include exposure processes, development processes or etching processes, the specific patterns in the formed layer structure may be continuous or discontinuous, and these specific patterns may also be at different heights or have different thicknesses.

In some examples, as shown in FIG. 7, a plurality of first line segments 21 are arranged along the first direction X and extend in the second direction Y. A line width direction of the first line segment 21 is parallel to the first direction X.

For example, the first line segment 21 located on the first main surface 11 of the substrate 10 is a straight line segment. That is, any two adjacent first line segments 21 among the plurality of first line segments 21 are parallel to each other. In this way, a length of the first line segment 21 may be minimized, which is conducive to reducing the size of the peripheral region SA.

In some examples, as shown in FIG. 9, a plurality of second line segments 22 are arranged along the first direction X and extend in the third direction Z. A line width direction of the second line segment 22 is parallel to the first direction X.

For example, the second line segment 22 located on the set side surface 13A of the substrate 10 is a straight line segment. That is, any two adjacent second line segments 22 among the plurality of second line segments 22 are parallel to each other. In addition, the second line segment 22 is perpendicular to the first main surface 11 and/or the second main surface 12. In this way, a length of the second line segment 22 may be minimized.

It will be noted that, if the set side surface 13A is unfolded on the plane where the first main surface 11 is located, the first line segment 21 and the second line segment 22 will extend in the same direction.

In some examples, as shown in FIG. 8, the second main surface 12 of the substrate 10 of the wiring substrate 100 has a fan-out region F. The third line segment 23 of the connection line 20 located on a side of the second main surface 12 of the substrate 10 away from the first main surface 11 includes a fan-out portion 231 located in the fan-out region F. The fan-out portion 231 gradually approaches a first central axis O1 of the wiring substrate 100 from an end of the fan-out portion 231 close to the second line segment 22 to an end of the fan-out portion 231 away from the second line segment 22.

The first central axis O1 of the wiring substrate 100 is perpendicular to a direction (first direction X) in which the connection lines 20 are arranged, and the first central axis O1 of the wiring substrate 100 is perpendicular to the third direction Z. That is, the first central axis O1 is parallel to the second direction Y.

Since each of a plurality of fan-out portions 231 is gradually close to the first central axis O1 of the wiring substrate 100 from an end thereof close to the second line segment 22 to an end thereof away from the second line segment 22. Based on the structure of the fan-out portion 231 described above, it can be seen that a line width direction of the fan-out portion 231 and the first direction X intersect.

As described above, the connection line 20 provided in this embodiment further includes the fan-out portion 231 located on a side of the second main surface 12 of the substrate 10. That is, the connection line 20 provided in this embodiment may be used to electrically connect the device on the first main surface 11 of the substrate 10 to the device on the second main surface 12. Furthermore, in this embodiment, a size, in the first direction X, of an end of the fan-out portion 231 of the connection line 20 close to the set side surface 13A is greater than a size, in the first direction X, of an end of the fan-out portion 231 away from the set side surface 13A, and a spacing between ends of two adjacent fan-out portions 231 close to the set side surface 13A in the first direction X is greater than a spacing between ends of the two adjacent fan-out portions 231 away from the set side surface 13A in the first direction X, so as to facilitate the subsequent electrical connection between the connection line 20 and the circuit board W of a specific size (as shown in FIG. 5). Therefore, there is no need to sequentially perform patterning processes on a side of the second main surface 12 of the substrate 10 of the wiring substrate 100 to form fan-out lines, and then, there is no need to perform multiple turnover operations on the wiring substrate 100. Thus, it may be possible to mitigate the problem of low reliability of the wiring substrate caused by the design and fabricating of wiring on both surfaces of the wiring substrate 100, and improve the quality of the wiring substrate 100.

In some examples, as shown in FIG. 8, in a direction perpendicular to the line widths of the plurality of connection lines 20 (the second direction Y), a length D3 of the fan-out region F is in a range of 3 mm to 20 mm. That is, in the direction perpendicular to the line widths of the plurality of connection lines 20 (the second direction Y), a length of the fan-out portion 231 of the third line segment 23 of the connection line 20 is in a range of 3 mm to 20 mm.

When the length D3 of the fan-out region F is equal to or close to 3 mm in the direction perpendicular to the line widths of the plurality of connection lines 20 (the second direction Y), the length of the fan-out region F is relatively small, which may save the material, reduce costs, improve design integration, and reduce the process difficulty of fabricating the connection lines 20.

When the length D3 of the fan-out region F is equal to or close to 20 mm in the direction perpendicular to the line widths of the plurality of connection lines 20 (the second direction Y), the length of the fan-out region F is relatively large. The size, in the first direction X, of the end of the fan-out portion 231 of the connection line 20 close to the set side surface 13A is greater than the size, in the first direction X, of the end of the fan-out portion 231 away from the set side surface 13A. Therefore, the larger the length D3 of the fan-out region F, the greater the difference between the size of the end of the fan-out portion 231 close to the set side surface 13A in the first direction X and the size of the end of the fan-out portion 231 away from the set side surface 13A in the first direction X, and the greater the difference between the spacing of the ends of two adjacent fan-out portions 231 close to the set side surface 13A in the first direction X and the spacing of the ends of the two adjacent fan-out portions 231 away from the set side surface 13A in the first direction X, which facilitates the subsequent electrical connection of the connection lines 20 and a smaller sized circuit board W (as shown in FIG. 5), and may reduce the costs of the circuit board W under the condition of meeting the process accuracy.

In some examples, as shown in FIG. 8, in the direction perpendicular to the line widths of the plurality of connection lines 20 (the second direction Y), the length D3 of the fan-out region F is in a range of 10 mm to 18 mm.

In the direction perpendicular to the line widths of the plurality of connection lines 20 (the second direction Y), the length D3 of the fan-out region F is in a range of 10 mm to 18 mm, which may not only meet the requirements for process accuracy when fabricating the connection lines 20, but also save material costs while the production time is ensured.

For example, in the direction perpendicular to the line widths of the plurality of connection lines 20 (the second direction Y), the length D3 of the fan-out region F is approximately any one of 3 mm, 5 mm, 8 mm, 10 mm, 12 mm, 15 mm, 18 mm, or 20 mm. However, the embodiments of the present disclosure are not limited thereto.

It will be noted that, considering the length D3 of the fan-out region F in the direction perpendicular to the line widths of the plurality of connection lines 20 (the second direction Y) being approximately 15 mm as an example for introduction, due to certain uncontrollable errors (such as manufacturing process errors, equipment accuracy, measurement errors, etc.), when the length D3 of the fan-out region F in the direction perpendicular to the line widths of the plurality of connection lines 20 (the second direction Y) fluctuates within a range of ±10% × 15 mm, it can also be considered that the length D3 of the fan-out region F in the direction perpendicular to the line widths of the plurality of connection lines 20 (the second direction Y) is equal to 15 mm.

In some embodiments, as shown in FIG. 8, the second main surface 12 further has a lead-out region R, and the lead-out region R is located on a side of the fan-out region F close to the set side surface 13A. The third line segment 23 of the connection line 20 further includes a lead-out portion 232 located in the lead-out region R. The lead-out portion 232 is used to connect the second line segment 22 and the fan-out portion 231. A plurality of lead-out portions 232 are arranged along the first direction X and extend in the second direction Y. An extending direction of the lead-out portion 232 of the third line segment 23 and an extending direction of the fan-out portion 321 of the third line segment 23 intersect.

For example, the lead-out portion 232 of the third line segment 23 located on the second main surface 12 of the substrate 10 may be understood as a straight line segment. That is, any two adjacent lead-out portions 232 among the plurality of lead-out portions 232 are parallel to each other. Furthermore, the lead-out portion 232 of the third line segment 23 is perpendicular to the side surface 13.

It will be noted that, if the set side surface 13A is unfolded on the plane where the second main surface 12 is located, the lead-out portion 232 and the second line segment 22 will extend in the same direction.

Based on this, the lead-out portion 232 is further provided on a side, close to the set side surface 13A, of the fan-out portion 231 of the third line segment 23 of the connection line 20, which facilitates the connection between the third line segment 23 and the second line segment 22.

In some examples, in the second direction Y, a length D4 of the lead-out portion 232 is in a range from 0.06 mm to 1 mm.

When the length D4 of the lead-out portion 232 in the second direction Y is equal to or close to 0.06 mm, the length of the lead-out portion 232 may be relatively small, thereby preventing the problem of the third line segment 23 being too long and causing increased difficulty in manufacturing. When the length D4 of the lead-out portion 232 in the second direction Y is equal to or close to 1 mm, the length of the lead-out portion 232 may be relatively large, thereby reducing the probability of forming the lead-out portion 232 of the third line segment 23 on the set side surface 13A, and also meeting the requirements for process accuracy when fabricating the connection lines 20.

In some other examples, the length D4 of the lead-out portion 232 in the second direction Y is in a range of 0.5 mm to 1 mm.

When the length D4 of the lead-out portion 232 is in a range of 0.5 mm to 1 mm, it may be possible to reduce the probability of forming the lead-out portion 232 of the third line segment 23 on the set side surface 13A. In addition, the length of the lead-out portion 232 may also meet the requirements for process accuracy when fabricating the connection lines 20.

For example, in the second direction Y, the length D4 of the lead-out portion 232 is approximately any one of 0.06 mm, 0.1 mm, 0.2 mm, 0.3 mm, 0.4 mm, 0.5 mm, 0.6 mm, 0.7 mm, 0.8 mm, 0.9 mm, or 1 mm. However, the embodiments of the present disclosure are not limited thereto.

It will be noted that, considering the length D4 of the lead-out portion 232 being approximately 0.8 mm as an example for introduction, due to certain uncontrollable errors (such as manufacturing process errors, equipment accuracy, measurement errors, etc.), when the length D4 of the lead-out portion 232 in the second direction Y and the length D3 of the fan-out region F fluctuate within a range of ±10% × 0.8 mm, it can also be considered that the length D4 of the lead-out portion 232 in the second direction Y is equal to 0.8 mm.

In some embodiments, in any one of the plurality of connection lines 20, extending directions of the lead-out portion 232, the first line segment 21 and the second line segment 22 that are connected in sequence are located in the same plane.

Based on this, if the set side surface 13A and the second main surface 12 of the substrate 10 are sequentially unfolded on the plane where the first main surface 11 of the substrate 10 is located, the connection line 20 formed by connecting the lead-out portion 232, the first line segment 21 and the second line segment 22 is a straight line segment, which may facilitate improving the regularity of the connection line 20 and improve the arrangement flexibility of the connection lines 20 in the wiring substrate 100.

In some examples, the plane is substantially perpendicular to the set side surface. In this way, the second line segment 22 may be substantially perpendicular to the first main surface 11 and/or the second main surface 12, so as to minimize the length of the second line segment 22.

It will be noted that, "substantially perpendicular" includes absolute perpendicularity and approximate perpendicularity. That is, the plane may intersect with the set side surface to form an angle of 90°. Alternatively, the plane may intersect with the set side surface to form an angle which is approximately 90°. For example, the angle formed by the plane intersecting with the set side surface may be in a range of 85° to 95°. For example, the plane may intersect with the set side surface to form an angle which is approximately any one of 85°, 90°, or 95°.

When the wiring substrate 100 is applied to a backplane, the connection lines 20 need to be electrically connected to the circuit board W. However, since the fan-out portions 231 of the plurality of third line segments 23 extend in different directions, it may be difficult for the fan-out portions 231 to be electrically connected to the circuit board W.

Based on this, in some embodiments, as shown in FIG. 8, the second main surface 12 further has a bonding region U, and the bonding region U is located on a side of the fan-out region F away from the set side surface 13A. The third line segment 23 of the connection line 20 further includes a bonding portion 233 located in the bonding region. A plurality of bonding portions 233 are arranged along the first direction X and extend in the second direction Y.

For example, any two bonding portions 233 among the plurality of bonding portions 233 extend in the same direction, e.g., perpendicular to the first direction X.

In this way, the bonding portion 233 is provided on a side of the fan-out portion 231 of the third line segment 23 away from the set side surface 13A. Since the plurality of bonding portions 233 extend in the same direction, the connection lines 20 may be connected to the circuit board W by using the bonding portions 233. Furthermore, the bonding portions 233 may be used to ameliorate the problem of difficulty in subsequent connection with the circuit board W due to the inconsistent extension directions of the fan-out portions 231.

For example, in the second direction Y, a length D5 of the bonding portion 233 is in a range of 0.9 mm to 2 mm.

When the length D5 of the bonding portion 233 in the second direction Y is equal to or close to 0.9 mm, it may be possible to meet the requirement of the connection between the bonding portions 233 and the circuit board W and facilitate the electrical connection between the connection lines 20 in the wiring substrate 100 and the circuit board W.

When the length D5 of the bonding portion 233 in the second direction Y is equal to or close to 2 mm, the length of the bonding portion 233 is relatively large, which is conducive to improving the stability of the connection between the bonding portions 233 and the circuit board W.

For example, in the second direction Y, the length D5 of the bonding portion 233 is approximately any one of 0.9 mm, 1 mm, 1.2 mm, 1.5 mm, 1.8 mm or 2 mm. However, the embodiments of the present disclosure are not limited thereto.

It will be noted that, considering the length D5 of the bonding portion 233 in the second direction Y being approximately 1.5 mm as an example for introduction, due to certain uncontrollable errors (such as manufacturing process errors, equipment accuracy, measurement errors, etc.), when the length D5 of the bonding portion 233 in the second direction Y fluctuates within a range of ±10% × 1.5 mm, it can also be considered that the length D5 of the bonding portion 233 in the second direction Y is equal to 1.5 mm.

In some embodiments, as shown in FIG. 8, the lead-out portion 232, the fan-out portion 231, and the bonding portion 233 of the third line segment 23 of the connection line 20 are sequentially connected to be of an integrated structure. That is, the lead-out portion 232, the fan-out portion 231 and the bonding portion 233 of the third line segment 23 are not sub-portions formed separately, but are the portions obtained by dividing the third line segment 23 based on different functions of positions of the third line segment 23, so as to clearly introduce the structure and function of the third line segment 23.

In some examples, the lead-out portion 232, the fan-out portion 231, and the bonding portion 233 of the third line segment 23 are arranged in the same layer.

It will be noted that, the "same layer" refers to a layer structure formed by forming a film layer for forming a specific pattern through a same film forming process and then performing a single patterning process using a same mask. Depending on different specific patterns, the patterning process may include exposure processes, development processes or etching processes, the specific patterns in the formed layer structure may be continuous or discontinuous, and these specific patterns may also be at different heights or have different thicknesses.

In some embodiments, as shown in FIG. 9, in the third direction Z, a length D6 of the second line segment 22 is substantially equal to a thickness of the substrate 10.

Based on this, when the second line segment 22 is used to connect the first line segment 21 (as shown in FIG. 7) located on the first main surface 11 of the substrate 10 to the third line segment 23 (as shown in FIG. 8) located on the second main surface 12 of the substrate 10, the probability of the second line segment 22 being formed on the first main surface 11 and the second main surface 12 of the substrate 10 is reduced.

In some embodiments, in the third direction Z, the length D6 of the second line segment 22 is in a range of 0.3 mm to 0.75 mm.

When the length D6 of the second line segment 22 is in a range of 0.3 mm to 0.75 mm, the length D6 of the second line segment 22 may be substantially equal to the thickness of the substrate 10. The second line segment 22 may extend from an end of the set side surface 13A of the substrate 10 close to the second main surface 12 to an end of the set side surface 13A close to the first main surface 11, so that the second line segment 22 on the set side surface 13A is used to connect the first line segment 21 (as shown in FIG. 7) on the first main surface 11 of the substrate 10 to the third line segment 23 (as shown in FIG. 8) located on the second main surface 12 of the substrate 10.

For example, in the third direction Z, the length D6 of the second line segment 22 is approximately any one of 0.3 mm, 0.4 mm, 0.5 mm, 0.55 mm, 0.6 mm, 0.65 mm, 0.7 mm or 0.75 mm. However, the embodiments of the present disclosure are not limited thereto.

It will be noted that, considering the length D6 of the second line segment 22 in the third direction Z being approximately 0.6 mm as an example for introduction, due to certain uncontrollable errors (such as manufacturing process errors, equipment accuracy, measurement errors, etc.), when the length D6 of the second line segment 22 in the third direction Z fluctuates within a range of ±10% × 0.6 mm, it can also be considered that the length D6 of the second line segment 22 in the third direction Z of the thickness of the substrate 10 is equal to 0.6 mm.

The situation that "in the third direction Z, the length D6 of the second line segment 22 is substantially equal to the thickness of the substrate 10" includes the following two manners.

In a first manner, in the third direction Z, the length D6 of the second line segment 22 is equal to the thickness of the substrate 10. That is, an end face of the second line segment 22 connected to the first line segment 21 is located in the same plane as the first main surface 11, and an end face of the second line segment 22 connected to the third line segment 23 is located in the same plane as the second main surface 12.

In this case, the first line segment 21 (as shown in FIG. 7) on the first main surface 11 may extend to slightly protrude from the first main surface 11, so that a portion of the first line segment 21 protruding from the first main surface 11 may be in contact with the second line segment 22 located on the set side surface 13A to realize the connection between the first line segment 21 and the second line segment 22.

For example, a length of the portion of the first line segment 21 protruding from the first main surface 11 is substantially equal to a thickness of the second line segment 22, so that the contact between the first line segment 21 and the second line segment 22 is realized.

Furthermore, the third line segment 23 on the second main surface 12 may extend to protrude from the second main surface 12, so that a portion of the third line segment 23 (as shown in FIG. 8) slightly protruding from the second main surface 12 may be in contact with the second line segment 22 located on the set side surface 13A to realize the connection between the third line segment 23 and the second line segment 22.

For example, a length of the portion of the third line segment 23 protruding from the second main surface 12 is substantially equal to the thickness of the second line segment 22, so that the contact between the third line segment 23 and the second line segment 22 is realized.

In a second manner, as shown in FIG. 9, in the third direction Z, the length D6 of the second line segment 22 is greater than the thickness of the substrate 10. In this case, in the third direction Z, two ends of the second line segment 22 may extend outward to slightly protrude from the set side surface 13A.

That is, an end of the second line segment 22 connected to the first line segment 21 (as shown in FIG. 7) extends outward to protrude from the first main surface 11 of the substrate 10, so that the second line segment 22 may extend to be in contact with the first line segment 21 located on the first main surface 11 to realize connection between the second line segment 22 and the first line segment 21.

For example, a length of a portion of the second line segment 22 protruding from the first main surface 11 of the substrate 10 is substantially equal to a thickness of the first line segment 21 located on the first main surface.

Furthermore, an end of the second line segment 22 connected to the third line segment 23 (as shown in FIG. 8) extends outward to protrude from the second main surface 12 of the substrate 10, so that the second line segment 22 may extend to be in contact with the third line segment 23 located on the second main surface 12 to realize the connection between the second line segment 22 and the third line segment 23.

For example, a length of a portion of the second line segment 22 protruding from the second main surface 12 of the substrate 10 is substantially equal to a thickness of the third line segment 23 located on the second main surface 12.

FIG. 11 is a schematic partial plan view of a front of a wiring substrate according to some embodiments. FIG. 12 is a schematic partial plan view of a front of a wiring substrate according to some other embodiments. FIGS. 11 and 12 are each a schematic partial plan view of the first main surface 11 of the substrate 10 of the wiring substrate 100.

In some embodiments, as shown in FIGS. 11 and 12, the main functional region AA of the wiring substrate 100 further includes device regions M in a plurality of rows and a plurality of columns, and the device regions M may be used to arrange functional devices Q (as shown in FIG. 4).

The wiring substrate 100 further includes a plurality of first electrodes P1, the plurality of first electrodes P1 are located on the side of the first main surface 11 of the substrate 10 away from the second main surface 12 of the substrate 10, and the plurality of first electrodes P1 are located on a side of the first main surface 11 of the substrate 10 close to the set side surface 13A. In this way, it may facilitate an electrical connection between the first electrode P1 located on the side of the first main surface 11 of the substrate 10 and the first line segment 21.

The above description that "the plurality of first electrodes P1 are located on the side of the first main surface 11 of the substrate 10 close to the set side surface 13A" may include the following two situations.

In a first situation, as shown in FIG. 11, the first electrodes P1 are located in the peripheral region SA, and the first electrodes P1 are electrically connected to the first line segments 21 of the connection lines 20.

Based on this, the connection lines 20 may be electrically connected to the functional devices Q (as shown in FIG. 4) arranged in the device regions M in the main functional region AA by using the first electrodes P1. Subsequently, the connection lines 20 are electrically connected to the circuit board W. Therefore, the functional devices Q may be electrically connected to the circuit board W by using the connection lines 20, to drive the functional devices Q.

In a second situation, as shown in FIG. 12, in the main functional region AA of the wiring substrate 100, a row of device regions M closest to the set side surface 13A among the plurality of rows of device regions M is defined as a target row M0. In the target row M0, two adjacent device region M have a first space M1 therebetween. The plurality of first electrodes P1 are located in a plurality of first spaces M1, and the first electrodes P1 are electrically connected to the first line segments 21 of the connection lines 20.

Based on this, the connection lines 20 may be electrically connected to the functional devices Q (as shown in FIG. 4) arranged in the device regions M in the main functional region AA by using the first electrodes P1. Subsequently, the connection lines 20 are electrically connected to the circuit board W. Therefore, the functional devices Q may be electrically connected to the circuit board W by using the connection lines 20, to drive the functional devices Q.

In addition, compared with the wiring substrate 100 shown in FIG. 11, in the wiring substrate 100 shown in FIG. 12, parts of the first electrodes P1 are disposed in the main functional region AA, which is beneficial for further reducing the space of the peripheral region SA.

Here, the description that "the plurality of first electrodes P1 are located in the plurality of first spaces M1" will be understood that one electrode P1 is located in one first space M1. That is, the first electrodes P1 are in one-to-one correspondence with the first spaces M1. FIG. 12 illustrates an example in which one electrode P1 is located in one first space M1. Alternatively, it will be understood that multiple electrodes P1 are located in one first space M1. However, the embodiments of the present disclosure are not limited thereto.

In some embodiments, as shown in FIGS. 11 and 12, in the direction in which the plurality of connection lines 20 are arranged (in the first direction X), a width of the first electrode P1 is greater than or equal to 0.05 mm. A maximum value of the width of the first electrode P1 may be adjusted according to the number of first electrodes P1 required for the wiring substrate 100.

Based on this, it may ensure that the contact resistance between the first electrode P1 and the connection line 20 meets the requirement, and it may also ensure that the first electrode P1 and the connection line 20 are stably connected.

For example, in the direction in which the plurality of connection lines 20 are arranged (in the first direction X), the width of the first electrode P1 is approximately 0.05 mm, 0.06 mm, 0.07 mm, 0.08 mm, 0.09 mm, 1 mm, or 1.5 mm. However, the embodiments of the present disclosure are not limited thereto.

It will be noted that, considering the width of the first electrode P1 in the direction in which the plurality of connection lines 20 are arranged (in the first direction X) being approximately 0.06 mm as an example for introduction, due to certain uncontrollable errors (such as manufacturing process errors, equipment accuracy, measurement errors, etc.), when the width of the first electrode P1 in the direction in which the plurality of connection lines 20 are arranged (in the first direction X) fluctuates within a range of ±10% × 0.06 mm, it can also be considered that the width of the first electrode P1 in the direction in which the plurality of connection lines 20 are arranged (in the first direction X) is equal to 0.06 mm.

In some embodiments, as shown in FIGS. 11 and 12, in a direction perpendicular to the direction in which the plurality of connection lines 20 are arranged (in the second direction Y), a length of the first electrode P1 is in a range of 0.05 mm to 0.2 mm.

When the length of the first electrode P1 in the direction perpendicular to the direction in which the plurality of connection lines 20 are arranged (in the second direction Y) is equal to or close to 0.05 mm, the length of the first electrode P1 is relatively small, which is conducive to reducing the size of the peripheral region SA of the wiring substrate 100. In addition, the first electrode P1 may be stably connected to the connection line 20.

When the length of the first electrode P1 in the direction perpendicular to the direction in which the plurality of connection lines 20 are arranged (in the second direction Y) is equal to or close to 0.2 mm, the length of the first electrode P1 is relatively large, which is conducive to improving the stability of the connection between the first electrode P1 and the connection line 20. In addition, the requirement of narrow bezel of the wiring substrate 100 may also be satisfied.

In some examples, as shown in FIGS. 11 and 12, in the direction perpendicular to the direction in which the plurality of connection lines 20 are arranged (in the second direction Y), the length of the first electrode P1 is in a range of 0.08 mm to 0.15 mm.

When the length of the first electrode P1 is in a range of 0.08 mm to 0.15 mm, it may ensure that the first electrode P1 is fixedly connected to the connection line 20 and meet the requirement of the narrow bezel of the wiring substrate 100. In addition, when the length of the first electrode P1 is in a range of 0.08 mm to 0.15 mm, the process difficulty may also be reduced.

For example, in the direction perpendicular to the direction in which the plurality of connection lines 20 are arranged (in the second direction Y), the length of the first electrode P1 is approximately any one of 0.05 mm, 0.08 mm, 0.1 mm, 0.12 mm, 0.15 mm, 0.18 mm or 2 mm. However, the embodiments of the present disclosure are not limited thereto.

It will be noted that, considering an example in which the length of the first electrode P1 in the direction perpendicular to the direction in which the plurality of connection lines 20 are arranged (in the second direction Y) is approximately 0.1 mm, due to certain uncontrollable errors (such as manufacturing process errors, equipment accuracy, measurement errors, etc.), when the length of the first electrode P1 in the direction perpendicular to the direction in which the plurality of connection lines 20 are arranged (in the second direction Y) fluctuates within a range of ±10% × 0.1 mm, it can also be considered that the length of the first electrode P1 is equal to 0.1 mm.

In some embodiments, as shown in FIGS. 11 and 12, in the direction in which the plurality of connection lines 20 are arranged (in the first direction X), the width of the connection line 20 is greater than or equal to a half of the width of the first electrode P1.

In this way, it may facilitate the fixed connection between the first electrode P1 and the connection line 20 and avoid disconnection.

In some examples, in the first direction X, the width of the connection line 20 is greater than or equal to the width of the first electrode P1.

Based on this, an orthographic projection of the first electrode P1 on the substrate 10 may be located within an orthographic projection of the connection line 20 on the substrate 10, which facilitates the fixed connection between the first electrode P1 and the connection line 20 and avoids disconnection.

In some embodiments, as shown in FIGS. 11 and 12, in the direction perpendicular to the direction in which the plurality of connection lines 20 are arranged (in the second direction Y), the length of the connection line 20 is greater than the length of the first electrode P1.

Based on this, the orthographic projection of the first electrode P1 on the substrate 10 may be located within the orthographic projection of the connection line 20 on the substrate 10, and the fixed connection between the first electrode P1 and the connection line 20 may be further ensured to avoid disconnection.

In some embodiments, as shown in FIGS. 11 and 12, in the direction perpendicular to the direction in which the plurality of connection lines 20 are arranged (in the second direction Y), the length of the first line segment 21 is in a range of 0.15 mm to 0.4 mm.

When the length of the first line segment 21 in the direction perpendicular to the direction in which the plurality of connection lines 20 are arranged (in the second direction Y) is equal to or close to 0.15 mm, the length of the first line segment 21 is relatively small, which is conducive to reducing the size of the peripheral region SA of the wiring substrate 100. In addition, the length of the first line segment 21 may be greater than or equal to a half of the length of the first electrode P1, so that the connection line 20 may be fixedly connected to the first electrode P1.

When the length of the first line segment 21 in the direction perpendicular to the direction in which the plurality of connection lines 20 are arranged (in the second direction Y) is equal to or close to 0.2 mm, the length of the first line segment 21 is relatively large, which is conducive to improving the stability of the connection between the first line segment 21 and the first electrode P1. In addition, the requirement of the narrow bezel of the wiring substrate 100 may also be satisfied.

In some examples, as shown in FIGS. 11 and 12, in the direction perpendicular to the direction in which the plurality of connection lines 20 are arranged (in the second direction Y), the length of the first line segment 21 is in a range of 0.15 mm to 0.25 mm.

When the length of the first line segment 21 in the direction perpendicular to the direction in which the plurality of connection lines 20 are arranged (in the second direction Y) is in a range of 0.15 mm to 0.25 mm, the length of the first line segment 21 may be greater than or equal to a half of the length of the first electrode P1, which may ensure that the first electrode P1 is fixedly connected to the connection line 20 and meet the requirement of the narrow bezel of the wiring substrate 100. In addition, when the length of the first line segment 21 is in a range of 0.15 mm to 0.25 mm, the process difficulty may also be reduced.

For example, in the direction perpendicular to the direction in which the plurality of connection lines 20 are arranged (in the second direction Y), the length of the first line segment 21 is approximately any one of 0.15 mm, 0.18 mm, 0.2 mm, 0.22 mm, 0.25 mm, 0.28 mm, 0.3 mm, 0.32 mm, 0.35 mm, 0.38 mm or 0.4 mm. However, the embodiments of the present disclosure are not limited thereto.

It will be noted that, considering the length of the first line segment 21 in the direction perpendicular to the direction in which the plurality of connection lines 20 are arranged (in the second direction Y) being approximately 0.18 mm as an example for introduction, due to certain uncontrollable errors (such as manufacturing process errors, equipment accuracy, measurement errors, etc.), when the length of the first line segment 21 in the direction perpendicular to the direction in which the plurality of connection lines 20 are arranged (in the second direction Y) fluctuates within a range of ±10% × 0.18 mm, it can also be considered that the length of the first line segment 21 is equal to 0.18 mm.

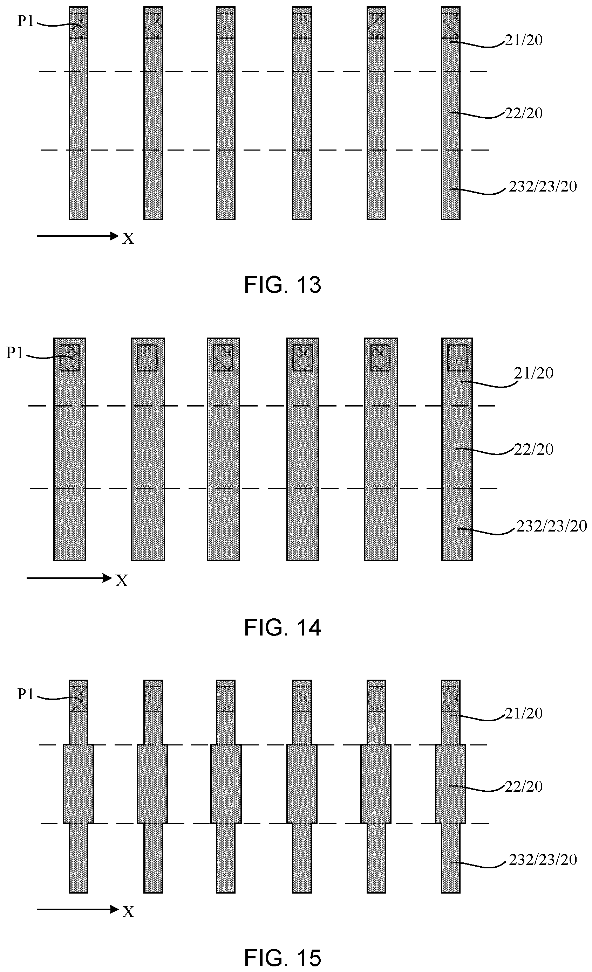

FIG. 13 is a partial view of connection lines according to some embodiments, which only illustrates the first line segments 21, the second line segments 22, and the lead-out portions 232 of the third line segments 23 in the connection lines 20.

In some embodiments, as shown in FIG. 13, in the direction in which the plurality of connection lines 20 are arranged (in the first direction X), the width of the first line segment 21, the width of the second line segment 22, and the width of the lead-out portion 232 of the third line segment 23 are substantially equal. In this way, the widths of the first line segment 21, the second line segment 22 and the lead-out portions 232 of the third line segment 23 that are sequentially connected in the connection line 20 may be equal, so that a shape of the connection line 20 is relatively regular, which is beneficial for the flexible arrangement of the connection line 20.

In some examples, the fan-out portions 231 (as shown in FIG. 8) of the third line segments 23 are arranged in the fan-out region F in a compact manner. Based on this, the line widths of the fan-out portions 231 of the third line segments 23 may be set to be small, so as to prevent fan-out portions 231 of two adjacent third line segments 23 from being short-circuited.

In the direction in which the plurality of connection lines 20 are arranged (in the first direction X), the width of the fan-out portion 231 (as shown in FIG. 8) of the third line segment 23 may be smaller than the line width of the lead-out portion 232 of the third line segment 23.

Based on this, the flexibility arrangement of the fan-out portions 231 of the third line segments 23 may be improved, and the spacing between the fan-out portions 231 of two adjacent third line segments 23 may be increased to reduce the probability of short circuit between the fan-out portions 231 of two adjacent third line segments 23.

In some examples, the bonding portion 233 (as shown in FIG. 8) of the third line segment 23 is required to be electrically connected to a circuit board of a small size.

Based on this, in the direction in which the plurality of connection lines 20 are arranged (in the first direction X), the width of the bonding portion 233 (as shown in FIG. 8) of the third line segment 23 may be smaller than the line width of the lead-out portion 232 of the third line segment 23.

In this way, the line width of the bonding portion 233 of the third line segment 23 may be small. As a result, the width of the bonding portion 233 of the third line segment 23 may match the circuit board, which facilitates the electrical connection between the bonding portion 233 of the third line segment 23 and the circuit board.

In some other examples, the width of the bonding portion 233 (as shown in FIG. 8) of the third line segment 23 may be smaller than the line width of the fan-out portion 231 (as shown in FIG. 8) of the third line segment 23.

The line width of the bonding portion 233 of the third line segment 23 is further reduced so as to facilitate electrical connection between the bonding portion 233 of the third line segment 23 and the circuit board.

FIG. 14 is a partial view of connection lines according to some other embodiments.

The difference between the connection line 20 shown in FIG. 14 and the connection line 20 shown in FIG. 13 is that the line width of the connection line 20 shown in FIG. 14 is greater than the line width of the connection line 20 shown in FIG. 13.

Based on this, as shown in FIG. 14, the line width of the first line segment 21 may be relatively increased, which may reduce the difficulty of connecting the first line segment 21 to the first electrode P1, and may help to reduce the contact resistance between the first line segment 21 and the first electrode P1, thereby ensuring the electrical performance of the wiring substrate 100.

In order to recognize the difference in line width between the connection line 20 shown in FIG. 13 and the connection line 20 shown in FIG. 14, FIGS. 13 and 14 also illustrate the first electrodes P1. It can be understood that the widths of the first electrodes P1 shown in FIGS. 13 and 14 are equal.

FIG. 15 is a partial view of connection lines according to yet some other embodiments.

In some embodiments, as shown in FIG. 15, in the same connection line 20, in the direction in which the plurality of connection lines 20 are arranged (in the first direction X), the width of the second line segment 22 is greater than the width of the first line segment 21.

In this way, the line width of the second line segment 22 disposed on the set side surface of the substrate may be greater than the line width of the first line segment 21 located on the first main surface of the substrate. Based on this, a contact area between the second line segment 22 and the set side surface of the substrate may be increased, thereby improving the stability of the second line segment 22 and the set side surface of the substrate.

In some embodiments, as shown in FIG. 15, in the same connection line 20, in the direction in which the plurality of connection lines 20 are arranged (in the first direction X), the width of the second line segment 22 is greater than the width of the lead-out portion 232 of the third line segment 23.

In this way, the width of the second line segment 22 disposed on the set side surface of the substrate is relatively large, which may facilitate increasing the contact area between the second line segment 22 and the set side surface of the substrate, thereby improving the stability of the second line segment 22 and the set side surface of the substrate.

In some examples, in the same connection line 20, the width of the lead-out portion 232 of the third line segment 23 may be smaller than the width of the first line segment 21. In this way, the lead-out portion 232 of the third line segment 23 may function as a transition line segment to prevent the connection line 20 from being easily damaged due to a sudden change in line width.

In some other examples, in the same connection line 20, the width of the first line segment 21 may be smaller than the width of the lead-out portion 232 of the third line segment 23. In this way, the width of the first line segments 21 may be relatively small, thereby facilitating increasing the spacing between adjacent first line segments 21 and preventing the problem of short circuit between the first line segments 21.

In yet some other examples, in the same connection line 20, the width of the lead-out portion 232 of the third line segment 23 may be equal to the width of the first line segment 21. In this way, the shape of the connection line 20 may be more regular, thus simplifying the manufacturing process.

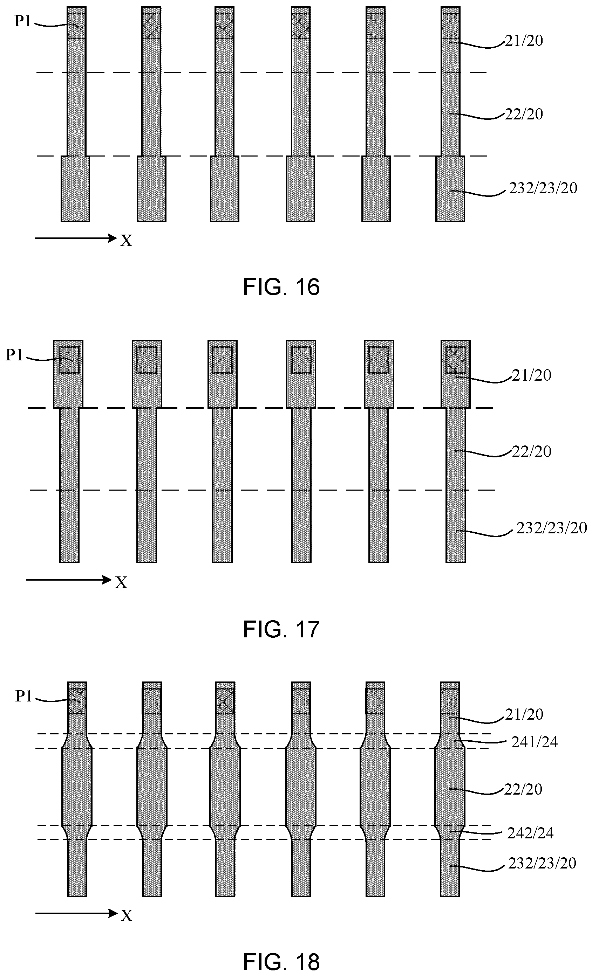

FIG. 16 is a partial view of connection lines according to yet some other embodiments.

In some embodiments, as shown in FIG. 16, in the same connection line 20, in the direction in which the plurality of connection lines 20 are arranged (in the first direction X), the width of the lead-out portion 232 of the third line segment 23 is greater than the width of the second line segment 22.

In this way, the width of the second line segment 22 may be relatively small, which facilitates the removal of a corresponding mask when the second line segment 22 of the connection line 20 is subsequently patterned, thereby reducing the difficulty of manufacturing.

In some embodiments, as shown in FIG. 16, the width of the lead-out portion 232 of the third line segment 23 is greater than the width of the first line segment 21.

In this way, the width of the first line segment 21 may be relatively small, thereby increasing the spacing between adjacent first line segments 21 and preventing the problem of short circuit between the first line segments 21.

In some examples, in the same connection line 20, in the direction in which the plurality of connection lines 20 are arranged (in the first direction X), the width of the first line segment 21 is greater than the width of the second line segment 22.

In some other examples, within the same connection line 20, in the direction in which the plurality of connection lines 20 are arranged (in the first direction X), the width of the second line segment 22 is greater than the width of the first line segment 21. **In** this way, the width of the first line segment 21 is relatively small, which is conducive to increasing the spacing between adjacent first line segments 21 and preventing the problem of short circuit between the first line segments 21.

In yet some other examples, within the same connection line 20, in the direction in which the plurality of connection lines 20 are arranged (in the first direction X), the width of the first line segment 21 is equal to the width of the second line segment 22. **In** this way, the shape of the connection line 20 may be more regular, thus simplifying the manufacturing process.

FIG. 17 is a partial view of connection lines according to yet some other embodiments.

In some embodiments, as shown in FIG. 17, in the same connection line 20, in the direction in which the plurality of connection lines 20 are arranged (in the first direction X), the width of the first line segment 21 is greater than the width of the second line segment 22.

In this way, the width of the first line segment 21 may be relatively large, which facilitates realizing that the width of the first line segment 21 is greater than the width of the first electrode, which in turn facilitates the electrical connection between the first line segment 21 and the first electrode.

In some embodiments, as shown in FIG. 17, in the same connection line 20, in the direction in which the plurality of connection lines 20 are arranged (in the first direction X), the width of the first line segment 21 is greater than the width of the lead-out portion 232 of the third line segment 23.

In this way, the width of the first line segment 21 may be relatively large, so as to facilitate the electrical connection between the first line segment 21 and the first electrode.

In some examples, in the same connection line 20, in the direction in which the plurality of connection lines 20 are arranged (in the first direction X), the width of the second line segment 22 is greater than the width of the lead-out portion 232 of the third line segment 23.

In this way, the width of the lead-out portion 232 of the third line segment 23 may be relatively small. Therefore, the lead-out portion 232 of the third line segment 23 may function as a transition line segment to prevent the connection line 20 from being easily damaged due to a sudden change in line width.

In some other examples, in the same connection line 20, in the direction in which the plurality of connection lines 20 are arranged (in the first direction X), the width of the second line segment 22 is smaller than the width of the lead-out portion 232 of the third line segment 23.

In this way, the width of the second line segment 22 may be relatively small, which facilitates the removal of a corresponding mask when the second line segment 22 of the connection line 20 is subsequently patterned, thereby reducing the difficulty of manufacturing.

In yet some other examples, in the same connection line 20, in the direction in which the plurality of connection lines 20 are arranged (in the first direction X), the width of the second line segment 22 is equal to the width of the lead-out portion 232 of the third line segment 23. In this way, the shape of the connection line 20 may be more regular, thus simplifying the manufacturing process.

It will be noted that in the wiring substrate 100 shown in FIG. 11, since the first line segment 21 of the connection line 20 is disposed in the peripheral region SA, there is no need to impose too many restrictions on the line width of the first line segment 21, as long as it ensures that the width of the first line segment 21 is greater than the width of the first electrode P1.

Therefore, the connection lines 20 shown in FIGS. 13 to 17 are all applicable to the wiring substrate 100 shown in FIG. 11.

However, in the wiring substrate 100 shown in FIG. 12, since the first electrode P1 is disposed in the first space M0, the first line segment 21 of the connection line 20 extends into the first space M0. Thus, the connection line 20 is electrically connected to the first electrode P1.

In order to prevent the connection line 20 from being short-circuited with the device in the device region M, the first line segment 21 of the connection line 20 and an adjacent device region M need to have a gap therebetween. That is, the line width of the first line segment 21 of the connection line 20 needs to be smaller than the width of the first space M0.

Therefore, some of the structures shown in FIGS. 13 to 17 in which the line width of the first line segment 21 of the connection line 20 is relatively small (the connection lines 20 shown in FIGS. 13, 15 and 16) are all applicable to the wiring substrate 100 shown in FIG. 12.

Since the connection lines in the wiring substrate 100 shown in FIG. 12 may be located in the first space M0, there is a need to ensure that a gap exists between the first line segment 21 and the adjacent device region M.

Based on this, when the connection lines 20 shown in FIGS. 14 and 17 are applied to the wiring substrate 100 shown in FIG. 12, the line width of the first line segment 21 needs to be adaptively increased to ensure that there is a gap between the first line segment 21 and the adjacent device region M while the line width of the first line segment 21 is increased.

As shown in FIGS. 13 to 17, in some embodiments, although line widths of portions of the connection lines 20 illustrated in FIGS. 13 and 14 are equal, FIGS. 13 and 14 do not illustrate the fan-out portions 231 and the bonding portions 233 of the third line segments 23 of the connection lines 20. There may be a case where the width of the fan-out portion 231 is smaller than the width of the lead-out portion 232.

Therefore, the connection line 20 shown in FIGS. 13 to 17 may have two adjacent portions with different line widths. In this case, a transition portion may be provided between two portions with different line widths in the connection line 20.

FIG. 18 is a partial view of connection lines according to yet some other embodiments.

In some embodiments, as shown in FIG. 18, the connection line 20 includes at least one transition portion 24, and the transition portion 24 is located between two portions with different line widths in the connection line 20, so as to connect the two portions with different line widths.

Based on this, the transition portion is used to alleviate the problem of sudden change in the line width of the connection line 20, so as to ensure the electrical performance of the connection line 20.

In some examples, when the line widths of the first line segment 21 and the second line segment 22 of the connection line 20 are not equal, the transition portion 24 includes a first transition portion 241, and the first transition portion 241 is used to connect the first line segment 21 and the second line segment 22.

Based on this, the line width of the connection line 20 may gradually change from the line width of the first line segment 21 to the line width of the second line segment 22 by using the first transition portion 241, thereby preventing the problem of sudden change in the line width of the connection line 20 due to a large difference between the line widths of the first line segment 21 and the second line segment 22.

In some examples, a line width of the first transition portion 241 gradually changes in the extending direction of the connection line 20; a line width of an end of the first transition portion 241 connected to the first line segment 21 is approximately equal to the line width of the first line segment 21; and a line width of an end of the first transition portion 241 connected to the second line segment 22 is approximately equal to the line width of the second line segment 22.

In this way, the line width of the connection line 20 may gradually change by using the first transition portion 241, thereby ameliorating the problem of sudden change in the line width of the connection line 20 and ensuring the electrical performance of the connection line 20.

In some examples, when the line widths of the third line segment 23 and the second line segment 22 of the connection line 20 are not equal, the transition portion 24 includes a second transition portion 242, and the second transition portion 242 is used to connect the third line segment 23 and the second line segment 22.

Based on this, the line width of the connection line 20 may gradually change from the line width of the third line segment 23 to the line width of the second line segment 22 by using the second transition portion 242, thereby preventing the problem of sudden change in the line width of the connection line 20 due to a large difference between the line widths of the third line segment 23 and the second line segment 22.

In some examples, a line width of the second transition portion 242 gradually changes in the extending direction of the connection line 20; a line width of an end of the second transition portion 242 connected to the third line segment 23 is approximately equal to the line width of the third line segment 23; and a line width of an end of the second transition portion 242 connected to the second line segment 22 is approximately equal to the line width of the second line segment 22.

In this way, the line width of the connection line 20 may gradually change by using the second transition portion 242, thereby ameliorating the problem of sudden change in the line width of the connection line 20 and ensuring the electrical performance of the connection line 20.

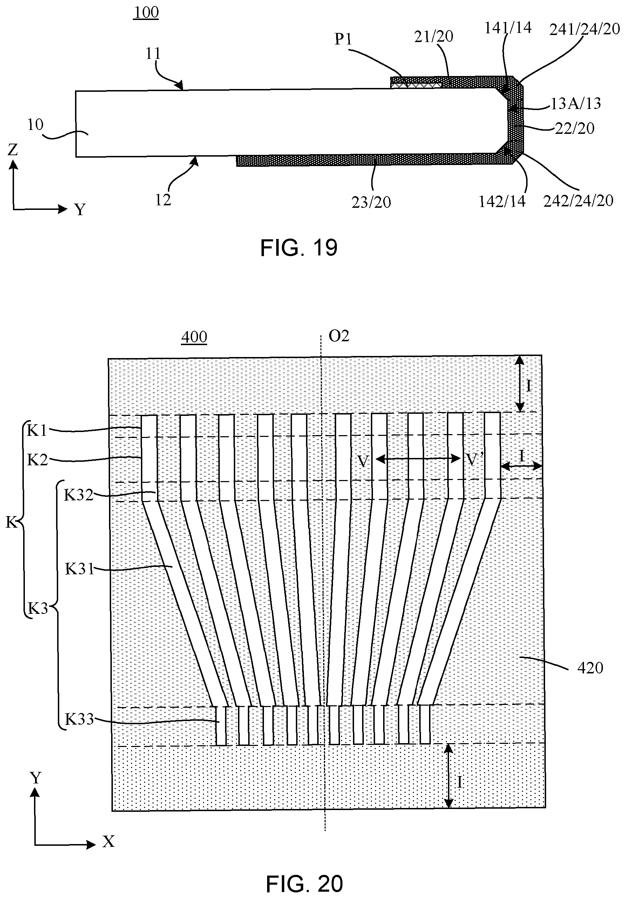

FIG. 19 is a sectional view of a wiring substrate according to some embodiments.

In some embodiments, as shown in FIG. 19, in the same connection line 20, a ratio of the thickness of the first line segment 21 to the thickness of the second line segment 22 is in a range of 0.3 to 0.8.

When the ratio of the thickness of the first line segment 21 to the thickness of the second line segment 22 is equal to or close to 0.3, the ratio of the thickness of the first line segment 21 to the thickness of the second line segment 22 is relatively small. That is, the thickness of the second line segment 22 is much greater than the thickness of the first line segment 21.

In this case, since the thickness of the second line segment 22 is relatively large, it is conducive to reducing the impedance of the connection line 20. In addition, since the thickness of the second line segment 22 is relatively large, the flatness of a surface of the second line segment 22 away from the set side surface 13A of the substrate 10 may be improved, which is conducive to improving the quality of the connection line 20.

In addition, since the length of the first line segment 21 is relatively large and the thickness of the first line segment 21 is relatively small, it is conducive to reducing the difficulty of fabricating the first line segment 21.

When the ratio of the thickness of the first line segment 21 to the thickness of the second line segment 22 is equal to or close to 0.8, the ratio of the thickness of the first line segment 21 to the thickness of the second line segment 22 is relatively large. That is, the thickness of the second line segment 22 is slightly greater than the thickness of the first line segment 21.

In this case, the thickness of the second line segment 22 in the case where the ratio of the thickness of the first line segment 21 to the thickness of the second line segment 22 is equal to or close to 0.8 is smaller than the thickness of the second line segment 22 in the case where the ratio of the thickness of the first line segment 21 to the thickness of the second line segment 22 is equal to 0.3, which is conducive to reducing the difficulty of fabricating the connection line 20, and in turn reducing the difficulty of removing the corresponding mask when subsequently patterning the second line segment 22 of the connection line 20. In addition, the surface of the second line segment 22 away from the set side surface 13A of the substrate 10 may have good flatness, so as to improve the quality of the connection line 20.

In addition, in this case, the thickness of the first line segment 21 is relatively large, so that the impedance of the connection line 20 may be further reduced.

It will be noted that when forming the second line segment 22 of any thickness, there are some uneven regions of the surface of the second line segment 22 away from the substrate 10 due to the unavoidable manufacturing process. Considering a pit in the uneven region as an example, the pit has a certain depth. When the thickness of the second line segment 22 is increased, a ratio of the depth of the pit to the second line segment 22 is reduced, thereby weakening the unevenness of the surface of the second line segment 22 away from the set side surface 13A of the substrate 10.

For example, in the same connection line 20, the ratio of the thickness of the first line segment 21 to the thickness of the second line segment 22 is approximately any one of 0.3, 0.4, 0.5, 0.6, 0.7 or 0.8.

It will be noted that, considering the ratio of the thickness of the first line segment 21 to the thickness of the second line segment 22 being approximately 0.5 as an example for introduction, due to certain uncontrollable errors (such as manufacturing process errors, equipment accuracy, measurement errors, etc.), when the ratio of the thickness of the first line segment 21 to the thickness of the second line segment 22 fluctuates within a range of ±10% × 0.5, it can also be considered that the ratio of the thickness of the first line segment 21 to the thickness of the second line segment 22 is equal to 0.5.

In some embodiments, as shown in FIG. 19, in the same connection line 20, a ratio of the thickness of the third line segment 23 to the thickness of the second line segment 22 is in a range of 0.3 to 0.8.

When the ratio of the thickness of the third line segment 23 to the thickness of the second line segment 22 is equal to or close to 0.3, the ratio of the thickness of the third line segment 23 to the thickness of the second line segment 22 is relatively small. That is, the thickness of the second line segment 22 is much greater than the thickness of the third line segment 23.

In this case, since the thickness of the second line segment 22 is relatively large, it is conducive to reducing the impedance of the connection line 20. In addition, since the thickness of the second line segment 22 is relatively large, the flatness of the surface of the second line segment 22 away from the set side surface 13A of the substrate 10 may be improved, which is conducive to improving the quality of the connection line 20.

In addition, since the length of the third line segment 23 is relatively large and the thickness of the third line segment 23 is relatively small, it is conducive to reducing the difficulty of fabricating the third line segment 23.

When the ratio of the thickness of the third line segment 23 to the thickness of the second line segment 22 is equal to or close to 0.8, the ratio of the thickness of the third line segment 23 to the thickness of the second line segment 22 is relatively large. That is, the thickness of the second line segment 22 is greater than the thickness of the first line segment 21.

In this case, the thickness of the second line segment 22 in the case where the ratio of the thickness of the third line segment 23 to the thickness of the second line segment 22 is equal to or close to 0.8 is smaller than the thickness of the second line segment 22 in the case where the ratio of the thickness of the third line segment 23 to the thickness of the second line segment 22 is equal to 0.3, which is conducive to reducing the difficulty of fabricating the connection line 20, and in turn reducing the difficulty of removing the corresponding mask when subsequently patterning the second line segment 22 of the connection line 20. In addition, the surface of the second line segment 22 away from the set side surface 13A of the substrate 10 may have good flatness, so as to improve the quality of the connection line 20.

In addition, in this case, the thickness of the third line segment 23 is relatively large, so that the overall impedance of the connection line 20 may be further reduced.

For example, in the same connection line 20, the ratio of the thickness of the third line segment 23 to the thickness of the second line segment 22 is approximately any one of 0.3, 0.4, 0.5, 0.6, 0.7 or 0.8. However, the embodiments of the present disclosure are not limited thereto.

It will be noted that, considering the ratio of the thickness of the third line segment 23 to the thickness of the second line segment 22 being approximately 0.5 as an example for introduction, due to certain uncontrollable errors (such as manufacturing process errors, equipment accuracy, measurement errors, etc.), when the ratio of the thickness of the third line segment 23 to the thickness of the second line segment 22 fluctuates within a range of ±10% × 0.5, it can also be considered that the ratio of the thickness of the third line segment 23 to the thickness of the second line segment 22 is equal to 0.5.

In some embodiments, as shown in FIG. 19, in the same connection line 20, the ratio of the thickness of the first line segment 21 to the thickness of the second line segment 22 is in a range of 0.3 to 0.8, and the ratio of the thickness of the third line segment 23 to the thickness of the second line segment 22 is in a range of 0.3 to 0.8.

In this case, the difficulty of patterning the first line segment 21 and the third line segment 23 may be reduced, and the surface of the second line segment 22 away from the set side surface 13A of the substrate 10 may have good flatness. **In** addition, the impedance of the connection line 20 may be reduced, so as to carry high current signal and improve the applicability of the wiring substrate 100.

In some embodiments, as shown in FIG. 19, the thickness of the second line segment 22 is in a range of 0.9 µm to 5 µm.

When the thickness of the second line segment 22 is equal to or close to 0.9 µm, the difficulty of patterning the second line segment 22 may be reduced, and the surface of the second line segment 22 away from the set side surface 13A of the substrate 10 may have good flatness; and the impedance of the connection line 20 may also be reduced to a certain extent.

When the thickness of the second line segment 22 is equal to or close to 5 µm, the flatness of the surface of the second line segment 22 away from the set side surface 13A of the substrate 10 may be well improved, and the impedance of the connection line 20 may be reduced. In addition, the requirements for patterning process of the second line segment 22 may also be satisfied.

In some examples, the thickness of the second line segment 22 is in a range of 2 µm to 4 µm. When the thickness of the second line segment 22 is in a range of 2 µm to 4 µm, the surface of the second line segment 22 away from the set side surface 13A of the substrate 10 may have good flatness, and the impedance may be reduced.

For example, the thickness of the second line segment 22 is approximately any one of 0.9 µm, 1 µm, 1.5 µm, 2 µm, 2.5 µm, 3 µm, 3.5 µm, 4 µm, 4.5 µm, or 5 µm. However, the embodiments of the present disclosure are not limited thereto.

It will be noted that, considering the thickness of the second line segment 22 being approximately 3 µm as an example for introduction, due to certain uncontrollable errors (such as manufacturing process errors, equipment accuracy, measurement errors, etc.), when the thickness of the second line segment 22 fluctuates within a range of ±10% × 3 µm, it can be considered that the thickness of the second line segment 22 is equal to 3 µm.

In some embodiments, as shown in FIG. 19, the thickness of the first line segment 21 is in a range of 0.6 µm to 2 µm.

When the thickness of the first line segment 21 is equal to or close to 0.6 µm, the thickness of the first line segment 21 is relatively small, which is conducive to reducing the difficulty of patterning a plurality of first line segments 21. In addition, due to the thickness of the first line segment 21, the impedance of the connection line 20 will not be too large.

When the thickness of the first line segment 21 is equal to or close to 2 µm, the thickness of the first line segment 21 is relatively large, which is conducive to reducing the impedance of the connection line 20; and the requirements for patterning process of the first line segment 21 may also be satisfied.

In some examples, the thickness of the first line segment 21 is in a range of 1 µm to 1.5 µm.

When the thickness of the first line segment 21 is in a range of 1 µm to 1.5 µm, it may be conducive to reducing the impedance of the connection line 20, and the requirements for patterning process of the first line segment 21 may be satisfied.

For example, the thickness of the first line segment 21 is approximately any one of 0.6 µm, 0.8 µm, 1 µm, 1.2 µm, 1.5 µm, 1.8 µm, or 2 µm. However, the embodiments of the present disclosure are not limited thereto.

It will be noted that, considering the thickness of the first line segment 21 being approximately 0.8 µm as an example for introduction, due to certain uncontrollable errors (such as manufacturing process errors, equipment accuracy, measurement errors, etc.), when the thickness of the first line segment 21 fluctuates within a range of ±10% × 0.8 µm, it can also be considered that the thickness of the first line segment 21 is equal to 0.8 µm.

In some embodiments, as shown in FIG. 19, the thickness of the third line segment 23 is in a range of 0.6 µm to 2 µm.

When the thickness of the third line segment 23 is equal to or close to 0.6 µm, the thickness of the third line segment 23 is relatively small, which is conducive to reducing the difficulty of patterning a plurality of third line segments 23. In addition, due to the thickness of the third line segment 23, the impedance of the connection line 20 will not be too large.

When the thickness of the third line segment 23 is equal to or close to 2 µm, the thickness of the third line segment 23 is relatively large, which is conducive to reducing the impedance of the connection line 20; and the requirements for patterning process of the third line segment 23 may also be satisfied.

In some examples, the thickness of the third line segment 23 is in a range of 1 µm to 1.5 µm.

When the thickness of the third line segment 23 is in a range of 1 µm to 1.5 µm, it may be conducive to reducing the impedance of the connection line 20, and the requirements for patterning process of the third line segment 23 may be satisfied.

For example, the thickness of the third line segment 23 is approximately any one of 0.6 µm, 0.8 µm, 1 µm, 1.2 µm, 1.5 µm, 1.8 µm, or 2 µm. However, the embodiments of the present disclosure are not limited thereto.

It will be noted that, considering the thickness of the third line segment 23 being approximately 0.8 µm as an example for introduction, due to certain uncontrollable errors (such as manufacturing process errors, equipment accuracy, measurement errors, etc.), when the thickness of the third line segment 23 fluctuates within a range of ±10% × 0.8 µm, it can also be considered that the thickness of the third line segment 23 is equal to 0.8 µm.

The above embodiments mainly introduce the structure of the connection line 20 in the wiring substrate 100 with reference to the relevant drawings. Based on the structure of the connection line 20, during the manufacturing process of the wiring substrate 100, the plurality of connection lines 20 extending from the first main surface 11 to the second main surface 12 through the set side surface 13A may be patterned by using one film forming process. How to form the plurality of connection lines 20 by using one film forming process during the manufacturing process of the wiring substrate 100 will be described in detail below with reference to the accompanying drawings. Firstly, a mask assembly 400 to be used in the manufacturing process of the wiring substrate 100 will be introduced with reference to the relevant drawings.

In some embodiments, as shown in FIG. 19, a transition side surface 14 is further provided between the set side surface 13A of the substrate 10 and the first main surface 11 or the second main surface 12. Compared with the case where the substrate 10 has an abrupt edge and sharp corner when boundaries of the set side surface 13A and the first main surface 11 directly coincide with each other and the set side surface 13A and the first main surface 11 are perpendicular to each other, in this way, the transition side surface 14 may be used to avoid the abrupt edge and sharp corner of the substrate 10, so as to avoid a problem that the substrate 10 is damaged due to the abrupt edge and sharp corner of the substrate 10 being subjected to an external force during transportation or storage, which reduces the quality of the wiring substrate 100. In addition, it may also facilitate the subsequent attachment of the mask assembly, and prevent the abrupt edge and sharp corner of the substrate 10 from damaging the mask assembly, which causes the reduction of the accuracy of the mask assembly.

In some embodiments, referring to FIGS. 18 and 19, when the substrate 10 includes a transition side surface 14, the transition portion 24 of the connection line 20 may be located on the transition side surface 14 of the substrate 10.

A transition side surface 14 between the set side surface 13A and the first main surface 11 is defined as a first transition side surface 141. In this case, the first transition portion 241 of the connection line 20 is located on the first transition side surface 141.

In this way, it may facilitate the first transition portion 241 to be in contact with the first line segment 21 located on the first main surface 11 and to be in contact with the second line segment 22 located on the set side surface 13A.

A transition side surface 14 between the set side surface 13A and the second main surface 12 is defined as a second transition side surface 142. In this case, the second transition portion 242 of the connection line 20 is located on the second transition side surface 142.

In this way, it may facilitate the second transition portion 242 to be in contact with the third line segment 23 located on the second main surface 12 and to be in contact with the second line segment 22 located on the set side surface 13A.

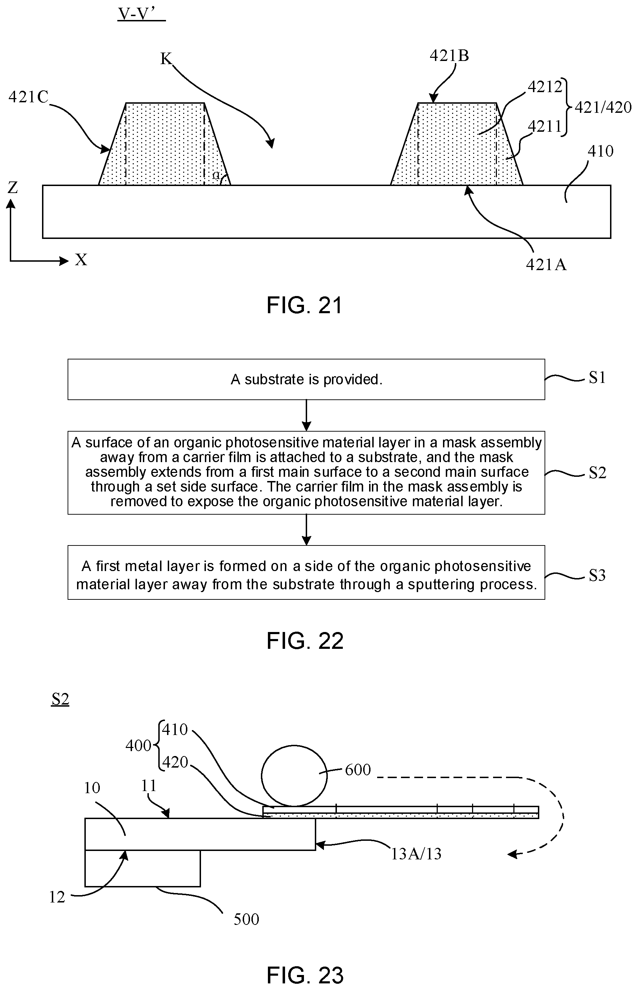

FIG. 20 is a structural diagram of a mask assembly according to some embodiments. FIG. 21 is a sectional view taken along the line V-V' in FIG. 20.

Some embodiments of the present disclosure provide a mask assembly 400, which is applied to the wiring substrate 100 as shown in FIGS. 7 to 10. Referring to FIGS. 20 and 21, the mask assembly 400 includes a carrier film 410 and an organic photosensitive material layer 420 located on the carrier film 410.

In some examples, a material of the carrier film 410 may include polyethylene terephthalate (PET) or polypropylene (PP). By using at least one of PET and PP to form the carrier film 410, the carrier film 410 may have certain supporting properties and certain bending properties, so as to facilitate the storage and transportation of the mask assembly 400.

In some embodiments, as shown in FIGS. 20 and 21, a thickness of the carrier film 410 is in a range of 25 µm to 75 µm.

When the thickness of the carrier film 410 is equal to or close to 25 µm, the carrier film 410 has a relatively small thickness, which may meet the support force requirements and have good bendability, so as to facilitate subsequent bonding with the wiring substrate 100.

When the thickness of the carrier film 410 is equal to or close to 75 µm, the carrier film 410 has a large thickness, which may meet the bending requirements and have good supporting force, so as to support the organic photosensitive material layer 420 formed on a surface of the carrier film 410.

In some examples, the thickness of the carrier film 410 is in a range of 30 µm to 50 µm.

When the thickness of the carrier film 410 is in a range of 30 µm to 50 µm, the carrier film 410 may have both good supporting force and good bendability, thereby improving the applicability of the mask assembly 400.

For example, the thickness of the carrier film 410 is approximately any one of 25 µm, 30 µm, 40 µm, 50 µm, 60 µm, 70 µm, or 75 µm. However, the embodiments of the present disclosure are not limited thereto.

Considering an example in which the thickness of the carrier film 410 is approximately 30 µm, in this case, the carrier film 410 may support the organic photosensitive material layer 420, and may also meet the bending requirements of the mask assembly 400.

It will be noted that due to certain uncontrollable errors (such as manufacturing process errors, equipment accuracy, measurement errors, etc.), when the thickness of the carrier film 410 fluctuates within a range of ±10% × 30 µm, it can also be considered that the thickness of the carrier film 410 is equal to 30 µm.

In some embodiments, referring to FIGS. 20 and 21, a material of the organic photosensitive material layer 420 may include at least one of a resin, polyol diluted acid esters, or methacrylate photopolymers. In addition, at least one of a photoinitiator, a plasticizer or a tackifier is added to the material of the organic photosensitive material layer 420. Based on this, the organic photosensitive material layer 420 may have good photosensitivity and good adhesion to facilitate subsequent bonding with the wiring substrate.

In some embodiments, referring to FIGS. 20 and 21, a thickness of the organic photosensitive material layer 420 is in a range of 25 µm to 50 µm.

When the thickness of the organic photosensitive material layer 420 is equal to or close to 25 µm, the thickness of the organic photosensitive material layer 420 is relatively small, and a resolution for patterning the organic photosensitive material layer 420 may be improved. That is, the accuracy of hollow regions K formed in the organic photosensitive material layer 420 may be improved, so as to improve the accuracy of the mask assembly 400. Furthermore, since the thickness of the organic photosensitive material layer 420 is relatively small, it may also facilitate the attaching of the mask assembly 400 to the wiring substrate.

When the thickness of the organic photosensitive material layer 420 is equal to or close to 50 µm, the thickness of the organic photosensitive material layer 420 is relatively large, and the organic photosensitive material layer 420 has good supporting force, which is convenient for storage and transportation. Furthermore, the accuracy requirements of the hollow regions K formed in the organic photosensitive material layer 420 by the mask assembly 400 may also be satisfied.

In some examples, the thickness of the organic photosensitive material layer 420 is in a range of 25 µm to 40 µm.

When the thickness of the organic photosensitive material layer 420 is in a range of 25 µm to 40 µm, the organic photosensitive material layer 420 may meet the accuracy requirements of the hollow regions K formed therein, and may also facilitate the attaching of the mask assembly 400 to the wiring substrate.

For example, the thickness of the organic photosensitive material layer 420 is approximately any one of 25 µm, 28 µm, 30 µm, 32 µm, 35 µm, 38 µm, 40 µm, 42 µm, 45 µm, 48 µm, or 50 µm. However, the embodiments of the present disclosure are not limited thereto.

It will be noted that, considering the thickness of the organic photosensitive material layer 420 being approximately 28 µm as an example for introduction, due to certain uncontrollable errors (such as manufacturing process errors, equipment accuracy, measurement errors, etc.), when the thickness of the organic photosensitive material layer 420 fluctuates within a range of ±10% × 28 µm, it can also be considered that the thickness of the organic photosensitive material layer 420 is equal to 28 µm.

In some examples, referring to FIGS. 20 and 21, the organic photosensitive material layer 420 includes a plurality of hollow regions K. In an extending direction of any hollow region K, the hollow region K includes a first hollow portion K1, a second hollow portion K2 and a third hollow portion K3 that are communicated in sequence. The third hollow portion K3 in any hollow region K gradually approaches a second central axis O2 of the mask assembly from a side thereof close to the second hollow portion K2 to a side thereof away from the second hollow portion K2. The second central axis O2 is perpendicular to a direction (second direction Y) in which the plurality of hollow regions K are arranged, and the second central axis O2 is perpendicular to the thickness direction (third direction) Z of the carrier film 410.

When the wiring substrate 100 shown in FIGS. 7 to 10 is manufactured using the mask assembly 400, one connection line 20 is formed through one hollow portion K. For any connection line 20, the first line segment 21 of the connection line 20 located on the first main surface 11 of the substrate 10 may be formed through the first hollow portion K1 of the hollow region K, the second line segment 22 of the connection line 20 located on the set side surface 13A of the substrate 10 may be formed through the second hollow portion K2 of the hollow region K, and the third line segment 23 of the connection line 20 located on the second main surface 12 of the substrate 10 may be formed through the third hollow portion K3 of the hollow region K.

Based on this, all parts of the connection line 20 may be simultaneously formed on the first main surface 11, the set side surface 13A and the second main surface 12 of the substrate 10 by using one film forming process. That is, a plurality of connection lines 20 extending from the first main surface 11 through the set side surface 13A to the second main surface 12 may be simultaneously formed on the substrate 10 of the wiring substrate 100 by using one film forming process.

Compared with the process of manufacturing the wiring substrate 100 in the related art shown in FIGS. 4 and 6, there is no need to design wiring and form the lines 012 on both the first main surface 11 and the second main surface 12 of the substrate 10 in the wiring substrate 100. Therefore, it may mitigate the problem of low reliability of the wiring substrate caused by the design and fabricating of wiring on both surfaces of the wiring substrate 100, and in turn improve the quality of the wiring substrate 100. In addition, since the wiring substrate 100 has a simple structure, it is conducive to reducing the costs of the wiring substrate 100 and realizing mass production.

In some examples, as shown in FIGS. 20 and 21, any one hollow region K has a plurality of sections made by planes parallel to the carrier film 410 cutting the hollow region K, and an area of a section closest to the carrier film 410 among the plurality of sections is smaller than an area of a section farthest from the carrier film 410 among the plurality of sections, which is equivalent to providing an opening area of any hollow region K close to the carrier film 410 to be smaller than an opening area of any hollow region K away from the carrier film 410.

In this way, when the mask assembly 400 is used for manufacturing the wiring substrate 100, it may facilitate patterning the plurality of connection lines 20 in the wiring substrate 100, so that the plurality of connection lines 20 extending from the first main surface 11 through the set side surface 13A to the second main surface 12 may be simultaneously formed on the substrate 10 of the wiring substrate 100 using one film forming process. Therefore, the design and fabricating of wiring only need to be performed on the first main surface of the wiring substrate 100, which is conducive to improving the reliability of the formed wiring substrate.

In some embodiments, the mask assembly 400 further includes a release film. The release film may be located on a surface of the organic photosensitive material layer 420 away from the carrier film 410. That is, the organic photosensitive material layer 420 may be sandwiched between the carrier film 410 and the release film.

Based on this, the release film may be used to protect the organic photosensitive material layer 420, thus facilitating the storage and transportation of the organic photosensitive material layer 420.

It will be noted that, when manufacturing the mask assembly 400, the organic photosensitive material layer 420 may be formed on the carrier film 410, and the organic photosensitive material layer 420 are patterned to form the plurality of hollow regions K. After the plurality of hollow regions K are formed in the organic photosensitive material layer 420, the release film is arranged on the surface of the organic photosensitive material layer 420 away from the carrier film 410.

Subsequently, when attaching the mask assembly 400 to the wiring substrate, the release film in the mask assembly 400 may be removed first to expose the organic photosensitive material layer 420 so that the surface of the organic photosensitive material layer 420 away from the carrier film 410 will be attached to the wiring substrate.

In some embodiments, a material of the release film may include polyethylene (PE). Polyethylene has good supporting force and corrosion resistance, and may protect the organic photosensitive material layer 420 to facilitate storage and transportation of the mask assembly 400.

In some examples, a thickness of the release film is in a range of 16 µm to 25 µm.

When the thickness of the release film is in a range of 16 µm to 25 µm, the release film may play a good role in protecting the organic photosensitive material layer 420, and may also be easily stripped from the surface of the organic photosensitive material layer 420.

For example, the thickness of the release film is approximately any one of 16 µm, 17 µm, 18 µm, 19 µm, 20 µm, 21 µm, 22 µm, 23 µm, 24 µm, or 25 µm. However, the embodiments of the present disclosure are not limited thereto.

It will be noted that, considering the thickness of the release film being approximately 18 µm as an example for introduction, due to certain uncontrollable errors (such as manufacturing process errors, equipment accuracy, measurement errors, etc.), when the thickness of the release film fluctuates within a range of ±10% × 18 µm, it can be considered that the thickness of the release film is equal to 18 µm.

In some embodiments, as shown in FIG. 20, the third hollow portion K3 includes a first hollow sub-portion K31, and the third hollow sub-portion K31 approaches the second central axis O2 of the mask assembly 400 from a side thereof close to the second hollow portion K2 to a side thereof away from the second hollow portion K2. The second central axis O2 is perpendicular to the direction (second direction Y) in which the plurality of hollow regions K are arranged, and the second central axis O2 is perpendicular to the thickness direction (third direction) Z of the carrier film 410.

Based on this, when the wiring substrate 100 shown in FIGS. 7 to 10 is manufactured using the mask assembly 400, one fan-out portion 231 may be formed through the first hollow sub-portion K31 of one third hollow portion K3. Thus, the plurality of connection lines 20 having fan-out portions 231 in the wiring substrate 100 may be simultaneously formed by one film forming process, which may mitigate the problem of low reliability of the wiring substrate caused by the design and fabricating of wiring on both surfaces of the wiring substrate 100, and in turn improve the quality of the wiring substrate 100.

Due to unavoidable process errors when attaching the mask assembly 400 to the substrate 10 in the wiring substrate 100, the fan-out portion 231 formed on the substrate 10 through the first hollow sub-portion K31 of the third hollow portion K3 may be offset to the set side surface 13A.

In light of this, in some examples, as shown in FIG. 20, the third hollow portion K3 further includes a second hollow sub-portion K32, and the second hollow sub-portion K32 is used to communicate the second hollow portion K2 and the first hollow sub-portion K31. The second hollow sub-portion K32 and the second hollow portion K2 extend in the same direction.

Therefore, the third hollow portion K3 further includes the second hollow sub-portion K32 extending in the same direction as the second hollow portion K2. Even if there is an attaching error, it will be considered that the lead-out portion 232 formed on the substrate 10 through the second hollow sub-portion K32 is offset to the set side surface 13A. If the set side surface 13A is unfolded on the plane where the second main surface 12 is located, the lead-out portion 232 and the second line segment 22 will extend in the same direction. Therefore, even if the lead-out portion 232 is offset to the set side surface 13A, it will not have a significant impact on the extending direction of the connection line 20 on the set side surface 13A. In addition, due to the second hollow sub-portion K32, it is conducive to reducing the probability that the fan-out portion 231 formed on the substrate 10 through the first hollow sub-portion K31 of the third hollow portion K3 is offset to the set side surface 13A.

In some examples, as shown in FIG. 20, the third hollow portion K3 further includes a third hollow sub-portion K33, and the third hollow sub-portion K33 is located on a side of the first hollow sub-portion K31 away from the second hollow portion K2.

When the wiring substrate 100 shown in FIG. 7 to FIG. 10 is manufactured using the mask assembly 400, one bonding portion 233 may be formed through the third hollow sub-portion K33 of one third hollow portion K3. Thus, the plurality of connection lines 20 having the fan-out portions 231 and the bonding portions 233 in the wiring substrate 100 may be simultaneously formed by one film forming process, which may mitigate the problem of low reliability of the wiring substrate caused by the design and fabricating of wiring on both surfaces of the wiring substrate 100, and in turn improve the quality of the wiring substrate 100.

It will be noted that lengths of the first hollow region K1, the second hollow region K2 and the third hollow region K3 in the mask assembly 400 may be adjusted according to the length of the connection line 20 to be formed, so as to improve the applicability of the mask assembly 400. In addition, the lengths of the first hollow sub-portion K31, the second hollow sub-portion K32 and the third hollow sub-portion K33 in the third hollow region K3 may also be adjusted according to the structure of the connection line 20 to be formed, so as to improve the applicability of the mask assembly 400.

The above embodiments mainly introduce the structure of the mask assembly 400 with reference to the relevant drawings. How to manufacture the wiring substrate 100 using the mask assembly 400 will be introduced below with reference to the relevant drawings.

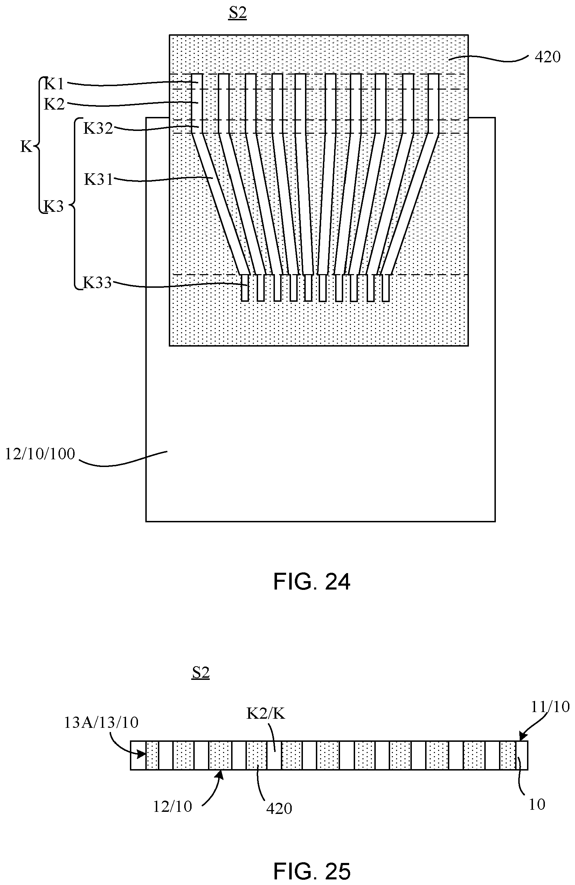

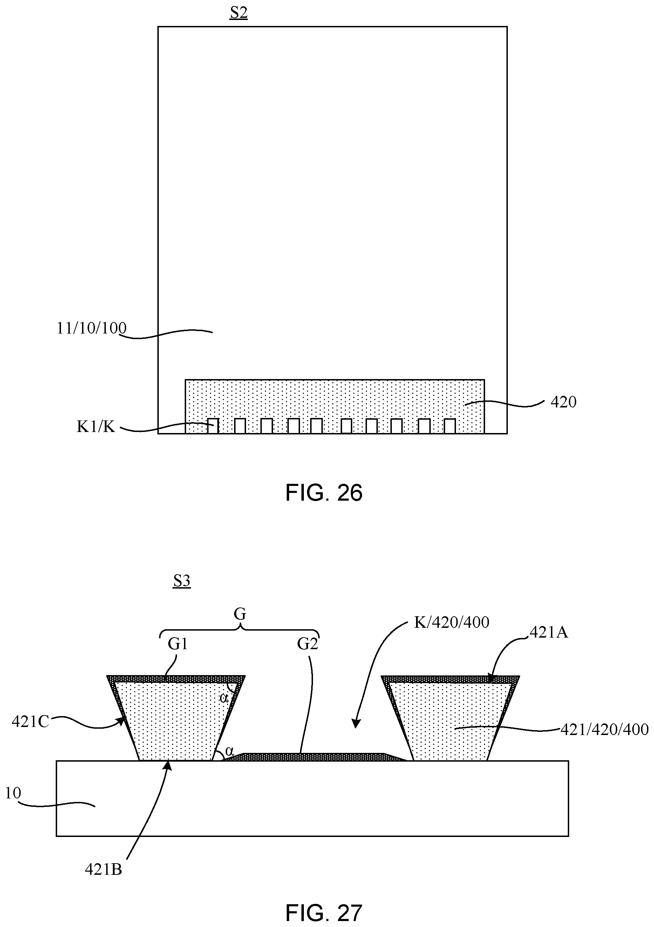

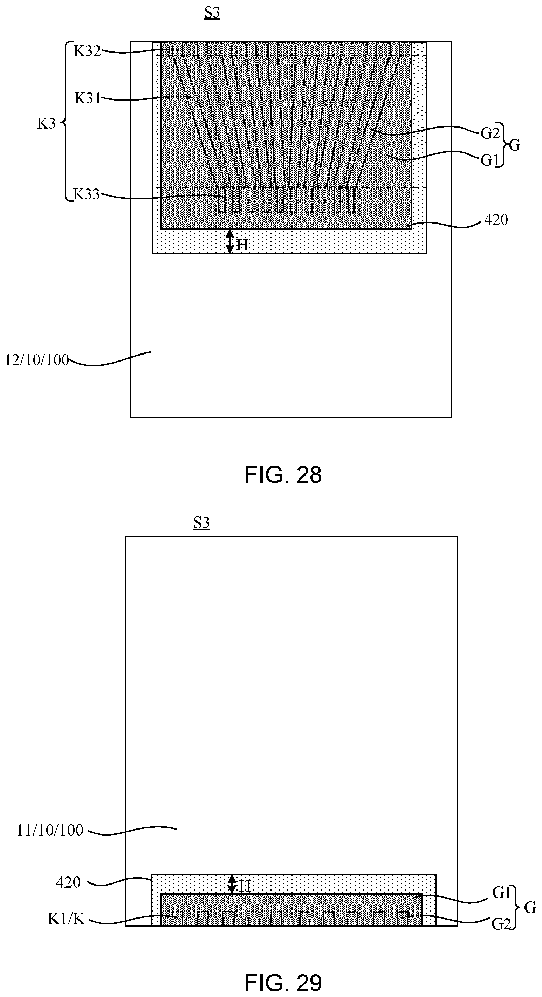

FIG. 22 is a flow diagram of a method of manufacturing a wiring substrate according to some embodiments. FIG. 23 is a diagram showing a structure corresponding to step S2 in FIG. 22. FIG. 24 is a diagram showing another structure corresponding to step S2 in FIG. 22. FIG. 25 is a diagram showing yet another structure corresponding to step S2 in FIG. 22. FIG. 26 is a diagram showing yet another structure corresponding to step S2 in FIG. 22. FIG. 27 is a diagram showing a structure corresponding to step S3 in FIG. 22. FIG. 28 is a diagram showing another structure corresponding to step S3 in FIG. 22. FIG. 29 is a diagram showing yet another structure corresponding to step S3 in FIG. 22.

Based on this, some embodiments of the present disclosure provide a method of manufacturing a wiring substrate 100. As shown in FIGS. 22 to 27, the method of manufacturing the wiring substrate 100 includes S1 in which a substrate 10 is provided. The substrate 10 includes a first main surface 11 and a second main surface 12 that are arranged opposite to each other in a thickness direction of the substrate 10, and side surfaces 13 located between the first main surface 11 and the second main surface 12. The side surfaces 13 are used to connect the first main surface 11 and the second main surface 12. A plurality of side surfaces 13 include a set side surface 13A corresponding to the peripheral region SA. It should be noted that the "set side surface S31" refers to a side surface 13 corresponding to the peripheral region SA among the plurality of side surfaces 13 of the substrate 10.

In some examples, before step S2, signal lines may be formed on the first main surface 11 of the substrate 10. The signal lines may be used to electrically connect devices in device regions of the wiring substrate 100 to connection lines.

Referring to FIGS. 23 to 26, in S2, a surface of an organic photosensitive material layer 420 in a mask assembly 400 away from a carrier film 410 is attached to the substrate 10, and the mask assembly 400 extends from the first main surface 11 to the second main surface 12 through the set side surface 13A. The carrier film 410 in the mask assembly 400 is removed to expose the organic photosensitive material layer 420.

Any hollow region K in the organic photosensitive material layer 420 may extend from the first main surface 11 to the second main surface 12 through the set side surface 13A. A first hollow portion K1 of the hollow region K is located on the first main surface 11 of the substrate 10, a second hollow portion K2 of the hollow region K is located on the set side surface 13A of the substrate 10, and a third hollow portion K3 of the hollow region K is located on the second main surface 12 of the substrate 10.

In step S2, when the mask assembly 400 is attached to the substrate 10, it is equivalent to arranging the organic photosensitive material layer 420 between the carrier film 410 and the substrate 10 of the wiring substrate 100.

At this time, it is equivalent to placing the mask assembly 400 upside down on the substrate 10 of the wiring substrate 100. A side of the hollow region K in the organic photosensitive material layer 420 close to the substrate 10 of the wiring substrate 100 is a side of the hollow region K in the organic photosensitive material layer 420 away from the carrier film 410.

There are a plurality of sections made by planes parallel to the carrier film 410, and an area of a section closest to the carrier film 410 among the plurality of sections is smaller than an area of a section farthest from the carrier film 410 among the plurality of sections, which is equivalent to providing an opening area of any hollow region K close to the carrier film 410 to be smaller than an opening area of any hollow region K away from the carrier film 410.

Based on this, any one hollow region K of the plurality of hollow regions K has a plurality of sections made by planes parallel to the carrier film 410 cutting the hollow region K, and an area of a section closest to the substrate 10 among the plurality of sections is greater than an area of a section farthest from the substrate 10 among the plurality of sections. That is, an opening area of the hollow region K close to the substrate 10 of the wiring substrate 100 is greater than an opening area of the hollow region K away from the substrate 10 of the wiring substrate 100. In this case, the hollow region K in the organic photosensitive material layer 420 cooperates with the substrate 10 to form a groove that is "narrow at the top and wide at the bottom".

In some examples, as shown in FIG. 23, in step S2, the substrate 10 of the wiring substrate 100 may be placed on a heating platform 500, and the heating platform 500 may heat the substrate 10. Based on this, when the surface of the organic photosensitive material layer 420 away from the carrier film 410 is in contact with the substrate 10, the substrate 10 may transfer heat to the organic photosensitive material layer 420. The organic photosensitive material layer 420 may have a certain degree of viscosity due to the characteristics of its material, so that the surface of the organic photosensitive material layer 420 away from the carrier film 410 may be attached to the substrate 10.

In some examples, a heating temperature provided by the heating platform 500 is in a range of 80°C to 170°C.

When the heating temperature provided by the heating platform 500 is equal to or close to 80°C, the temperature at which the substrate 10 is heated is relatively low, which may avoid the risk of other devices on the substrate 10 being damaged by high temperature. In addition, the organic photosensitive material layer 420 may also have a certain viscosity, which meets the requirements of attaching the organic photosensitive material layer 420 to the substrate 10.

When the heating temperature provided by the heating platform 500 is equal to or close to 170°C, the viscosity of the organic photosensitive material layer 420 may be relatively high, so as to fix the organic photosensitive material layer 420 and the substrate 10. Furthermore, other devices on the substrate 10 will not be damaged by high temperature.

For example, the heating temperature provided by the heating platform 500 is approximately 80°C, 100°C, 120°C, 150°C, or 170°C. However, the embodiments of the present disclosure are not limited thereto.

It will be noted that, considering the heating temperature provided by the heating platform 500 being approximately 150°C as an example for introduction, due to certain uncontrollable errors (such as manufacturing process errors, equipment accuracy, measurement errors, etc.), when the heating temperature provided by the heating platform 500 fluctuates within a range of ±10% × 150°C, it can also be considered that the heating temperature provided by the heating platform 500 is equal to 150°C.

In some examples, in step S2, after the substrate 10 is heated by the heating platform 500, the surface of the organic photosensitive material layer 420 away from the carrier film 410 may be attached to the substrate 10 by rolling.

For example, as shown in FIG. 23, a roller 600 may be pushed to roll in a direction from the first main surface 11 to the set side surface 13A and then to the second main surface 12 of the substrate 10 to apply force to the organic photosensitive material layer 420, so that the surface of the organic photosensitive material layer 420 away from the carrier film 410 is in contact with the substrate 10. However, the embodiments of the present disclosure are not limited thereto.

As shown in FIG. 27, in S3, a first metal layer G is formed on a side of the organic photosensitive material layer 420 away from the substrate 10 through a sputtering process.

In step S4, portions of the first metal layer G are blocked by the organic photosensitive material layer 420 and formed on the organic photosensitive material layer 420, and other portions of the first metal layer G are directly formed on the substrate 10 due to the hollow regions K. The portions of the first metal layer G formed on the organic photosensitive material layer 420 are defined as first portions G1 of the first metal layer G, and the portions of the first metal layer G formed on the substrate 10 through the hollow regions K are defined as second portions G2 of the first metal layer G.

However, since the groove has a structure that is "narrow at the top and wide at the bottom" and is not vertical to the substrate, an end, close to the organic photosensitive material layer 420, of the first portion of the first metal layer 440 formed in the groove has a small thickness, and there is a gap between the connection line 20 and the organic photosensitive material layer 420. That is, the first portion G1 of the first metal layer G and the second portion G2 of the first metal layer G are not in direct contact with each other, and they have a gap therebetween.

Based on this, the organic photosensitive material layer 420 and the first portions G1 of the first metal layer G on the organic photosensitive material layer 420 are removed by using the gaps, leaving the second portions G2 of the first metal layer G to be patterned into a plurality of connection lines 20.

In some examples, in step S3, the substrate is placed in a sputtering chamber with a self-rotatable stage, and a metal material is sputtered on the first main surface 11, the set side surface 13A, and the second main surface 12 of the substrate 10 to form the first metal layer G.

When forming the first metal layer G, a thickness of the first metal layer G located on the set side surface 13A may be greater than a thickness of the first metal layer G on the first main surface 11, and the thickness of the first metal layer G located on the set side surface 13A may be greater than a thickness of the first metal layer G on the second main surface 12.

In this way, it is conducive to reducing the low surface flatness of the first metal layer G located on the set side surface 13A of the substrate 10. In addition, due to a small length of the first metal layer G located on the set side surface 13A of the substrate 10, increasing its thickness will not affect the difficulty of removing the organic photosensitive material layer 420 at this location.

In some examples, after forming the first metal layer G, the organic photosensitive material layer 420 and the first portions G1 of the first metal layer G located on the organic photosensitive material layer 420 may be removed by using an etching process, leaving the second portions G2 of the first metal layer G to be patterned into the plurality of connection lines 20.

For example, after the first metal layer G is formed, it may be immersed in an etching solution. At this time, the etching solution may be in contact with and react with the organic photosensitive material layer 420 through the gaps between the first portions G1 of the first metal layer G and the second portions G2 of the first metal layer G, so as to peel off the organic photosensitive material layer 420.

The etching solution may include at least one of: alcohol, potassium hydroxide (KOH), sodium hydroxide (NaOH), or other weak alkali or weak acid solutions. However, the embodiments of the present disclosure are not limited thereto.

In some other embodiments, the organic photosensitive material layer 420 and the first portions G1 of the first metal layer G on the organic photosensitive material layer 420 may be removed by using ultrasonic wave.

In some examples, in step S2, the surface of the organic photosensitive material layer 420 in the mask assembly 400 away from the carrier film 410 may be attached to the substrate 10 through an adhesive layer.

Based on this, in step S3, after forming the first metal layer G, the first portions G1 of the first metal layer G located on the organic photosensitive material layer 420 and the organic photosensitive material layer 420 may be peeled off, leaving the second portions G2 of the first metal layer G to be patterned into the plurality of connection lines 20.

As shown in FIGS. 28 and 29, in some examples, after forming the first metal layer G, the first metal layer G1 and an edge of the organic photosensitive material layer 420 have a minimum spacing H therebetween, and a length of the minimum spacing H is greater than or equal to 2 mm.

In this way, it may avoid a problem that when forming the first metal layer G, the first metal layer G is formed outside the organic photosensitive material layer 420, which causes contamination of the substrate of the wiring substrate 100 and affects the subsequent fabrication of other devices on the wiring substrate 100.

In summary, in the mask assembly 400 used in the method in this embodiment, there are a plurality of sections made by planes parallel to the carrier film 410, and an area of a section closest to the carrier film 410 among the plurality of sections is smaller than an area of a section farthest from the carrier film 410 among the plurality of sections. When the mask assembly 400 is attached to the substrate 10 of the wiring substrate 100, the mask assembly 400 is placed upside down on the substrate 10 of the wiring substrate 100. Thus, an opening area of the hollow region K close to the substrate 10 of the wiring substrate 100 may be greater than an opening area of the hollow region K away from the substrate 10 of the wiring substrate 100. The hollow region K in the organic photosensitive material layer 420 may cooperate with the substrate 10 to form a groove that is "narrow at the top and wide at the bottom". Furthermore, when forming the first metal layer G1, the first portion G1 of the first metal layer G and the second portion G2 of the first metal layer G may have a gap therebetween. The organic photosensitive material layer 420 and the first portions G1 of the first metal layer G on the organic photosensitive material layer 420 are removed by using gaps, and the second portions G2 of the first metal layer G are retained to be patterned into a plurality of connection lines 20.

Based on this, when manufacturing the wiring substrate 100, a plurality of connection lines 20 extending from the first main surface 11 through the set side surface 13A to the second main surface 12 may be simultaneously formed on the substrate 10 of the wiring substrate 100 through one film forming process. In addition, there is no need to perform multiple turn-over operations on the wiring substrate 100, and it may be possible to mitigate the problem of low reliability of the wiring substrate caused by the design and fabricating of wiring on both surfaces of the wiring substrate 100 and improve the quality of the wiring substrate 100.

In some embodiments, referring to FIGS. 20, 21 and 16, the organic photosensitive material layer 420 in the mask assembly 400 further includes a plurality of first photosensitive sub-portions 421, and the first photosensitive sub-portion 421 separates two adjacent hollow regions K. The first photosensitive sub-portion 421 includes a third surface 421A and a fourth surface 421B that are arranged opposite to each other. The third surface 421A of the first photosensitive sub-portion 421 is closer to the carrier film 410 than the fourth surface 421B of the first photosensitive sub-portion 421.

Based on the structure of the hollow region K, any one hollow region K has a plurality of sections made by planes parallel to the carrier film 410 cutting the hollow region K, and and an area of a section closest to the carrier film 410 among the plurality of sections is smaller than an area of a section farthest from the carrier film 410 among the plurality of sections. In this case, an area of the third surface 421A of the first photosensitive sub-portion 421 may be greater than an area of the fourth surface 421B of the first photosensitive sub-portion 421.

In a direction in which the plurality hollow regions K are arranged (in the first direction X), the first photosensitive sub-portion 421 further includes two second side surfaces 421C arranged opposite to each other, and the second side surfaces 421C of the first photosensitive sub-portion 421 are used to connect the third surface 421A and the fourth surface 421B of the second side surface 421C.

It will be noted that, in the direction in which the plurality hollow regions K are arranged (in the first direction X), a space between two adjacent first photosensitive sub-portions 421 is a hollow region K. That is, among two adjacent first photosensitive sub-portions 421, a second side surface 421C of one first photosensitive sub-portion 421 close to another first photosensitive sub-portion 421 may be understood as an interface between the hollow region and the first photosensitive sub-portion 421.

Based on this, the relative position relationship between the second side surface 421C of the first photosensitive sub-portion 421 and the substrate 10 will change based on a shape of the hollow region K. Therefore, the shape of the hollow region K may be described based on the relative position relationship between the second side surface 421C of the first photosensitive sub-portion 421 and the substrate 10.

Referring to FIGS. 21 and 27, in some examples, any one hollow region K of the plurality of hollow regions K may have a plurality of sections made by planes parallel to the carrier film 410 cutting the hollow region K; and among any two sections of the plurality of sections, an area of a section closer to the carrier film 410 is smaller than an area of a section farther away from the carrier film 410.

When manufacturing the wiring substrate using the mask assembly 400, any one hollow region K of the plurality of hollow regions K has a plurality of sections made by planes parallel to the substrate 10 cutting the hollow region K; and among any two sections of the plurality of sections, an area of a section closer to the carrier film 410 is greater than an area of a section farther away from the substrate 10.

In this way, it is equivalent to providing the second side surface 421C of the first photosensitive sub-portion 421 to be inclined on the substrate 10, and an extending surface of the second side surface 421C of the first photosensitive sub-portion 421 may intersect with the substrate 10 to form an acute angle.

Based on this, when the first metal layer G is formed on the first main surface 11, the set side surface 13A and the second main surface 12 of the substrate 10, due to the structure of the hollow region K and the first photosensitive sub-portion 421, the first metal layer G will be blocked by two ends of the first photosensitive sub-portion 421, and the first metal layer G (the second portion G2 of the first metal layer G) formed on the substrate 10 through the hollow region K cannot be in contact with the first metal layer G (the first portion G1 of the first metal layer G) located on the first photosensitive sub-portion 421. That is, there is a gap between the second portion G2 of the first metal layer G and the first portion G1 of the first metal layer G. Furthermore, when subsequently removing the organic photosensitive material layer 420 and the first portion G1 of the first metal layer G located on the organic photosensitive material layer 420, the gap may be used to break through the first metal layer G to prevent the first metal layer G from surrounding the organic photosensitive material layer 420 and causing the problem of being unable to remove the organic photosensitive material layer 420.

In some examples, any one hollow region K of the plurality of hollow regions K may have a plurality of sections made by planes parallel to the carrier film 410 cutting the hollow region K; and among the plurality of sections, the closer the section is to the carrier film 410, the smaller the area of the section is.

In some embodiments, as shown in FIGS. 20, 21 and 27, a section of any one hollow region K of the plurality of hollow regions K made by a plane perpendicular to an extending direction of the hollow region K cutting the hollow region K is in a shape of a trapezoid. That is, a section of any one first photosensitive sub-portion 421 of the plurality of first photosensitive sub-portions 421 made by a plane perpendicular to an extending direction of the first photosensitive sub-portion 421 cutting the first photosensitive sub-portion 421 is in a shape of a trapezoid.

In the mask assembly 400, a trapezoid corresponding to the first photosensitive sub-portion 421 is a regular trapezoid, and a trapezoid corresponding to the hollow region K is an inverted trapezoid. When the mask assembly 400 is placed upside down on the substrate 10 in the wiring substrate, the trapezoid corresponding to the first photosensitive sub-portion 421 is an inverted trapezoid, and the trapezoid corresponding to the hollow region K is a regular trapezoid.

In this way, when manufacturing the wiring substrate using the mask assembly 400, that is, when forming the first metal layer G on the first main surface 11, the set side surface 13A and the second main surface 12 of the substrate 10, the first metal layer G (the second portion G2 of the first metal layer G) cannot completely cover the second side surfaces 421C of the first photosensitive sub-portion 421, and the first metal layer G (the first portion G1 of the first metal layer G) cannot completely cover the substrate 10 between two first photosensitive sub-portions 421.

Based on this, the first portion G1 of the first metal layer G is disconnected from the second portion G2 of the first metal layer G, so that a gap exists between the second portion G2 of the first metal layer G and the first portion G1 of the first metal layer G. Furthermore, when subsequently removing the organic photosensitive material layer 420 and the first portions G1 of the first metal layer G located on the organic photosensitive material layer 420, the first metal layer G may be disconnected due to the gap, to prevent the first metal layer G from surrounding the organic photosensitive material layer 420 and causing the problem of being unable to remove the organic photosensitive material layer 420. Therefore, it is conducive to improving the reliability of the formed wiring substrate.

**In** some embodiments, referring to FIGS. 20, 21 and 27, the extending surface of the second side surface 421C of the first photosensitive sub-portion 421 intersects with the carrier film 410 to form a first angle α, and the first angle α may be in a range of 40° to 80°. When manufacturing the wiring substrate using the mask assembly 400, an angle formed by an intersection of the extending surface of the second side surface 421C of the first photosensitive sub-portion 421 and the substrate 10 is approximately equal to the first angle α. FIG. 27 illustrates an example in which the angle formed by the intersection of the extending surface of the second side surface 421C of the first photosensitive sub-portion 421 and the substrate 10 is equal to the first angle α.

When the first angle α is equal to or close to 40°, an angle formed between the second side surface 421C of the first photosensitive sub-portion 421 and the carrier film 410 is relatively small, so that an inclination of the second side surface 421C of the first photosensitive sub-portion 421 is relatively large. Based on this, a difference between an opening size of the hollow region K close to the carrier film 410 and an opening size of the hollow region K away from the carrier film 410 is increased.

Furthermore, when forming the connection lines in the wiring substrate 100 by using the mask assembly 400, thicknesses of two edges, in a line width direction of the second portion G2, of the second portion G2 of the first metal layer G formed on the carrier film 410 through the hollow region K will be small. **In** this way, a spacing between the second portion G2 of the first metal layer G formed through the hollow region K and the first photosensitive sub-portion 421 may be increased, and a spacing between the connection line 20 and the first portion G1 of the first metal layer G on the second side surface 421C of the first photosensitive sub-portion 421 may be increased, which facilitates removing the first photosensitive sub-portions 421 and the first portions G1 of the first metal layer G on the surfaces of the first photosensitive sub-portions 421; and the second portions G2 of the first metal layer G formed through the hollow regions K are retained to form the plurality of connection lines 20.

When the first angle α is equal to or close to 80°, the angle formed between the second side surface 421C of the first photosensitive sub-portion 421 and the carrier film 410 is relatively large, so that the inclination of the second side surface 421C of the first photosensitive sub-portion 421 is relatively small. Furthermore, when forming the connection lines in the wiring substrate 100 by using the mask assembly 400, it may be possible to disconnect the second portion G2 of the first metal layer G and the first portion G1 of the first metal layer G, so as to facilitate the removal of the first photosensitive sub-portions 421. In addition, it may also avoid a problem that the gap between the second portion G2 of the first metal layer G and the first portion G1 of the first metal layer G is too large, which causes a distance between the plurality of connection lines 20 formed subsequently is too large and reduces the total number of connection lines 20.

In some examples, the first angle α is in a range of 45° to 70°.

When the first angle α is in a range of 45° to 70°, the second portion G2 of the first metal layer G and the first portion G1 of the first metal layer G may be disconnected to facilitate the removal of the first photosensitive sub-portions 421, and the requirement for the number of connection lines 20 in the wiring substrate 100 may be satisfied.

For example, the first angle α is approximately any one of 40°, 45°, 50°, 55°, 60°, 65°, 70°, 75° or 80°. However, the embodiments of the present disclosure are not limited thereto.

It will be noted that, considering the first angle α being approximately 60° as an example for introduction, due to certain uncontrollable errors (such as manufacturing process errors, equipment accuracy, measurement errors, etc.), when the first angle α fluctuates within a range of ±10% × 60°, it can also be considered that the first angle αis equal to 60°.

In some embodiments, as shown in FIGS. 20, 21 and 27, in the direction in which the plurality of hollow regions are arranged (the first direction X), a length of the second side surface 421C is in a range of 6 µm to 25 µm. That is, a projection length of an orthographic projection of the second side surface 421C on the carrier film 410 in the direction in which the plurality of hollow regions are arranged (the first direction X) is in a range of 6 µm to 25 µm.

When the length of the second side surface 421C in the direction in which the plurality of hollow regions are arranged (the first direction X) is equal to or close to 6 µm, the inclination of the second side surface 421C of the first photosensitive sub-portion 421 is relatively small. Furthermore, when forming the connection lines in the wiring substrate 100 by using the mask assembly 400, it may be possible to disconnect the second portion G2 of the first metal layer G and the first portion G1 of the first metal layer G, so as to facilitate the removal of the first photosensitive sub-portions 421. In addition, it may also avoid a problem that the gap between the second portion G2 of the first metal layer G and the first portion G1 of the first metal layer G is too large, which causes a distance between the plurality of connection lines 20 formed subsequently is too large and reduces the total number of connection lines 20.

When the length of the second side surface 421C in the direction in which the plurality of hollow regions are arranged (the first direction X) is equal to or close to 25 µm, the inclination of the second side surface 421C of the first photosensitive sub-portion 421 is relatively large. Based on this, the difference between the opening size of the hollow region K close to the carrier film 410 and the opening size of the hollow region K away from the carrier film 410 is increased.

Furthermore, when forming the connection lines in the wiring substrate 100 by using the mask assembly 400, thicknesses of two edges, in a line width direction of the second portion G2, of the second portion G2 of the first metal layer G formed on the substrate 10 through the hollow region K will be small. In this way, a spacing between the second portion G2 of the first metal layer G formed through the hollow region K and the first photosensitive sub-portion 421 may be increased, and a spacing between the connection line 20 and the first portion G1 of the first metal layer G on the second side surface 421C of the first photosensitive sub-portion 421 may be increased, which facilitates removing the first photosensitive sub-portions 421 and the first portions G1 of the first metal layer G on the surfaces of the first photosensitive sub-portions 421; and the second portions G2 of the first metal layer G formed through the hollow regions K are retained to form the plurality of connection lines 20.

In some examples, in the direction in which the plurality of hollow regions are arranged (the first direction X), the length of the second side surface 421C of the first photosensitive sub-portion 421 is in a range of 8 µm to 15 µm. That is, a projection length of an orthographic projection of the second side surface 421C of the first photosensitive sub-portion 421 on the substrate 10 is in a range of 8 µm to 15 µm.

When the length of the second side surface 421C of the first photosensitive sub-portion 421 in the direction in which the plurality of hollow regions are arranged (the first direction X) is in a range of 8µm to 15µm, the second side surface 421C of the first photosensitive sub-portion 421 may have a good inclination. Therefore, the second portion G2 of the first metal layer G and the first portion G1 of the first metal layer G may be disconnected to facilitate the removal of the first photosensitive sub-portions 421, and the requirement for the number of connection lines 20 in the wiring substrate 100 may be satisfied.

For example, the length of the second side surface 421C of the first photosensitive sub-portion 421 in the direction in which the plurality of hollow regions are arranged (the first direction X) is approximately any one of 6 µm, 8 µm, 10 µm, 12 µm, 15 µm, 18 µm, 20 µm, 22 µm or 25 µm. However, the embodiments of the present disclosure are not limited thereto.

It will be noted that, considering the length of the second side surface 421C of the first photosensitive sub-portion 421 in the direction in which the plurality of hollow regions are arranged (the first direction X) being approximately 10 µm as an example for introduction, due to certain uncontrollable errors (such as manufacturing process errors, equipment accuracy, measurement errors, etc.), when the length of the second side surface 421C of the first photosensitive sub-portion 421 in the direction in which the plurality of hollow regions are arranged (the first direction X) fluctuates within a range of ±10% × 10 µm, it can also be considered that the length of the second side surface 421C of the first photosensitive sub-portion 421 in the direction in which the plurality of hollow regions are arranged (the first direction X) is equal to 10 µm.

In some embodiments, referring to FIGS. 20, 21 and 27, in the direction in which the plurality of hollow regions are arranged (the first direction X), a length of the first photosensitive sub-portion 421 is in a range of 49 µm to 88 µm.

When the length of the first photosensitive sub-portion 421 is equal to or close to 49 µm, the distance between the plurality of connection lines 20 may be small, which facilitates the arrangement of a larger number of connection lines and improves the applicability of the wiring substrate 100. Furthermore, it may be possible to form an inclined second side surface 421C of the first photosensitive sub-portion 421.

When the length of the first photosensitive sub-portion 421 is equal to or close to 88 µm, the distance between the plurality of connection lines 20 may be large, which may prevent the plurality of connection lines 20 from being short-circuited. Furthermore, since the length of the first photosensitive sub-portion 421 is relatively large, it may be possible to improve the flexibility of arranging the second side surface 421C of the first photosensitive sub-portion 421.

For example, the length of the first photosensitive sub-portion 421 is approximately any one of 49 µm, 49.5 µm, 50 µm, 60 µm, 70 µm, 80 µm, 87.5 µm, or 88 µm. However, the embodiments of the present disclosure are not limited thereto.

It will be noted that, considering the length of the first photosensitive sub-portion 421 in the direction in which the plurality of hollow regions are arranged (the first direction X) being approximately 49.5 µm as an example for introduction, due to certain uncontrollable errors (such as manufacturing process errors, equipment accuracy, measurement errors, etc.), when the length of the first photosensitive sub-portion 421 in the direction in which the plurality of hollow regions are arranged (the first direction X) fluctuates within a range of ±10% × 49.5 µm, it can also be considered that the length of the first photosensitive sub-portion 421 in the direction in which the plurality of hollow regions are arranged (the first direction X) is equal to 49.5 µm.

In some embodiments, referring to FIGS. 20, 21 and 27, a ratio of a length of the fourth surface 421B of the first photosensitive sub-portion 421 in the direction in which the plurality of hollow regions are arranged (the first direction X) to the thickness of the organic photosensitive material layer 420 is in a range of 1 to 2.

When the ratio of the length of the fourth surface 421B of the first photosensitive sub-portion 421 to the thickness of the organic photosensitive material layer 420 is equal to or close to 1, the length of the fourth surface 421B of the first photosensitive sub-portion 421 is relatively small, so that the distance between the plurality of connection lines 20 may be small, which facilitates the arrangement of a larger number of connection lines and improves the applicability of the wiring substrate 100. Furthermore, it may be possible to form an inclined second side surface 421C of the first photosensitive sub-portion 421.

When the ratio of the length of the fourth surface 421B of the first photosensitive sub-portion 421 to the thickness of the organic photosensitive material layer 420 is equal to or close to 2, the length of the fourth surface 421B of the first photosensitive sub-portion 421 is relatively large, so that the distance between the plurality of connection lines 20 may be large, which may prevent the plurality of connection lines 20 from being short-circuited. Furthermore, it may be possible to form an inclined second side surface 421C of the first photosensitive sub-portion 421.

In some examples, the ratio of the length of the fourth surface 421B of the first photosensitive sub-portion 421 in the direction in which the plurality of hollow regions are arranged (the first direction X) to the thickness of the organic photosensitive material layer 420 is in a range of 1.3 to 1.8.

When the ratio of the length of the fourth surface 421B of the first photosensitive sub-portion 421 in the direction in which the plurality of hollow regions are arranged (the first direction X) to the thickness of the organic photosensitive material layer 420 is in a range of 1.3 to 1.8, the distance of the plurality of connection lines 20 formed subsequently may be moderate, thereby meeting the requirements for the number of connection lines 20 in the wiring substrate 100.

For example, the ratio of the length of the fourth surface 421B of the first photosensitive sub-portion 421 in the direction in which the plurality of hollow regions are arranged (the first direction X) to the thickness of the organic photosensitive material layer 420 is approximately 1, 1.2, 1.4, 1.5, 1.6, 1.8 or 2. However, the embodiments of the present disclosure are not limited thereto.

In some embodiments, as shown in FIG. 20, the hollow region K and an edge of the organic photosensitive material layer 420 have a first spacing I therebetween, and a length of the first spacing I is greater than or equal to 2 mm.

In this way, it may avoid a problem that when forming the plurality of connection lines 20, metal is formed outside the organic photosensitive material layer 420, which causes contamination of the substrate of the wiring substrate 100 and affects the subsequent fabrication of other devices on the wiring substrate 100.

In some examples, in the extending direction of any hollow region K, the hollow region K and an edge of the organic photosensitive material layer 420 have a first spacing I therebetween, and a length of the first spacing I is greater than or equal to 2 mm.

In this way, it may avoid a problem that when forming the plurality of connection lines 20, metal is formed outside the organic photosensitive material layer 420, which causes contamination of the substrate of the wiring substrate 100, affects the subsequent connection between the connection lines and the circuit board, and affects the subsequent fabrication of devices on other positions of the first main surface of the substrate.

In some examples, in the direction in which the plurality of hollow regions K are arranged, the hollow region K and an edge of the organic photosensitive material layer 420 have a first spacing I therebetween, and a length of the first spacing I is greater than or equal to 2 mm.

In this way, it may avoid a problem that when forming the plurality of connection lines 20, metal is formed outside the organic photosensitive material layer 420, which causes difficulty in subsequently forming other devices on the wiring substrate 100.

The foregoing descriptions are merely specific implementation manners of the present disclosure, but the protection scope of the present disclosure is not limited thereto. Any changes or replacements that a person skilled in the art could conceive of within the technical scope of the present disclosure shall be included in the protection scope of the present disclosure. Therefore, the protection scope of the present disclosure shall be subject to the protection scope of the claims.

## Claims

1. A wiring substrate, comprising:
a substrate, including a first main surface and a second main surface arranged opposite to each other in a thickness direction of the substrate, and side surfaces between the first main surface and the second main surface, wherein the side surfaces include a set side surface; and
a plurality of connection lines located on the substrate, wherein the connection lines extend from the first main surface through the set side surface to the second main surface;
any one connection line of the plurality of connection lines includes a first surface and a second surface that are arranged opposite to each other, the first surface is closer to the substrate than the second surface, and an area of the first surface is greater than an area of the second surface.

2. The wiring substrate according to claim 1, wherein any one connection line of the plurality of connection lines has a plurality of sections made by planes parallel to the substrate cutting the connection line; and among any two sections of the plurality of sections, an area of a section closer to the substrate is smaller than an area of another section farther away from the substrate.

3. The wiring substrate according to claim 1 or 2, wherein a section of any one connection line of the plurality of connection lines made by a plane perpendicular to an extending direction of the connection line cutting the connection line is in a shape of a trapezoid.

4. The wiring substrate according to any one of claims 1 to 3, wherein in a line width direction of the connection line, the connection line includes two first side surfaces arranged opposite to each other; the first side surfaces are used to connect the first surface and the second surface;
a projection length of an orthographic projection of a first side surface on the substrate in the line width direction of the connection line is in a range of 6 µm to 25 µm.

5. The wiring substrate according to any one of claims 1 to 4, wherein
any one connection line of the plurality of connection lines includes: a first line segment, a second line segment and a third line segment that are connected in sequence; the first line segment is located on the first main surface, the second line segment is located on the set side surface, and the third line segment is located on the second main surface;
the second main surface has a fan-out region, and a length of the fan-out region in a direction perpendicular to a direction in which the plurality of connection lines are arranged is in a range of 3 mm to 20 mm; the third line segment includes a fan-out portion located in the fan-out region; the fan-out portion gradually approaches a first central axis of the wiring substrate from an end of the fan-out portion close to the second line segment to an end of the fan-out portion away from the second line segment; and the first central axis is perpendicular to the direction in which the plurality of connection lines are arranged.

6. The wiring substrate according to claim 5, wherein a length of the first line segment is in a range of 0.15 mm to 0.4 mm.

7. The wiring substrate according to claim 5 or 6, wherein the second main surface further has a lead-out region, and the lead-out region is located on a side of the fan-out region close to the set side surface;
the third line segment further includes a lead-out portion located in the lead-out region, the lead-out portion is used to connect the second line segment and the fan-out portion, and a length of the lead-out portion is in a range of 0.06 mm to 1 mm.

8. The wiring substrate according to claim 7, wherein in any one connection line of the plurality of connection lines, extending directions of the first line segment, the second line segment and the lead-out portion that are connected in sequence are located in a same plane.

9. The wiring substrate according to any one of claims 5 to 8, wherein a ratio of a thickness of the first line segment to a thickness of the second line segment is in a range of 0.3 to 0.8; and/or
a ratio of a thickness of the third line segment to the thickness of the second line segment is in a range of 0.3 to 0.8.

10. The wiring substrate according to any one of claims 5 to 9, wherein a thickness of the second line segment is in a range of 0.9 µm to 5 µm;
a thickness of the first line segment is in a range of 0.6 µm to 2 µm; and/or
a thickness of the third line segment is in a range of 0.6 µm to 2 µm.

11. The wiring substrate according to any one of claims 1 to 10, further comprising:
a plurality of first electrodes, wherein the first electrodes are located on the first main surface and close to the set side surface, and a first electrode is electrically connected to a first line segment of the connection line.

12. A mask assembly, used for manufacturing the plurality of connection lines in the wiring substrate according to any one of claims 1 to 11, the mask assembly comprising:
a carrier film; and
an organic photosensitive material layer located on a side of the carrier film, wherein the organic photosensitive material layer includes a plurality of hollow regions; any one hollow region of the plurality of hollow regions has a plurality of sections made by planes parallel to the carrier film cutting the hollow region; among the plurality of sections, an area of a section closest to the carrier film is smaller than an area of a section farthest from the carrier film;
in an extending direction of any one hollow region, the hollow region includes a first hollow portion, a second hollow portion and a third hollow portion that are communicated in sequence; the third hollow portion in any one the hollow region gradually approaches a second central axis of the mask assembly from a side of the third hollow portion close to the second hollow portion to a side of the third hollow portion away from the second hollow portion; and the second central axis is perpendicular to a direction in which the plurality of hollow regions are arranged.

13. The mask assembly according to claim 12, wherein any one hollow region of the plurality of hollow regions has the plurality of sections made by planes parallel to the carrier film cutting the hollow region; and among any two sections of the plurality of sections, an area of a section closer to the carrier film is smaller than an area of a section farther away from the carrier film.

14. The mask assembly according to claim 12 or 13, wherein a section of any one hollow region of the plurality of hollow regions made by a plane perpendicular to an extending direction of the hollow region cutting the hollow region is in a shape of a trapezoid.

15. The mask assembly according to any one of claims 12 to 14, wherein in a direction in which the plurality of hollow regions are arranged, the organic photosensitive material layer further includes first photosensitive sub-portions; a first photosensitive sub-portion separates two adjacent hollow regions;
in the direction in which the plurality of hollow regions are arranged, the first photosensitive sub-portion includes two second side surfaces; and a second side surface intersects with the carrier film to form a first angle, and the first angle is in a range of 40° to 80°.

16. The mask assembly according to claim 15, wherein a projection length of an orthographic projection of the second side surface on the carrier film in the direction in which the plurality of hollow regions are arranged is in a range of 6 µm to 25 µm.

17. The mask assembly according to any one of claims 12 to 16, wherein a thickness of the organic photosensitive material layer is in a range of 25 µm to 50 µm.

18. The mask assembly according to any one of claims 12 to 17, wherein in an extending direction of any one hollow region, the hollow region and an edge of the organic photosensitive material layer have a first spacing therebetween, and a length of the first spacing is greater than or equal to 2 mm.

19. A backplane, comprising:
a plurality of functional elements;
at least one circuit board; and
the wiring substrate according to any one of claims 1 to 11, wherein an end of the connection line in the wiring substrate is connected to a functional element, and another end of the connection line is connected to the circuit board.

20. A display device, comprising:
a backlight module, the backlight module including the backplane according to claim 19, wherein the functional elements include light-emitting diodes; and
a liquid crystal display panel located on a light exit side of the backlight module.

21. A display device, comprising:
a display panel, the display panel including at least one backplane according to claim 19, wherein the functional elements include light-emitting diodes.
